(19) Europäisches Patentamt
European Patent Office
Office européen des brevets

(11) EP 2 093 268 B1

(12) EUROPEAN PATENT SPECIFICATION

(45) Date of publication and mention of the grant of the patent:
**25.03.2015 Bulletin 2015/13**

(21) Application number: **07850249.9**

(22) Date of filing: **07.12.2007**

(51) Int Cl.:
***C09J 7/02*** *(2006.01)* ***B32B 27/00*** *(2006.01)*
***C09J 133/00*** *(2006.01)*

(86) International application number:
**PCT/JP2007/073644**

(87) International publication number:
**WO 2008/075570 (26.06.2008 Gazette 2008/26)**

# (54) PRESSURE-SENSITIVE ADHESIVE SHEET

HAFTKLEBEFOLIE

FEUILLE ADHÉSIVE SENSIBLE À LA PRESSION

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **18.12.2006 JP 2006340237**

(43) Date of publication of application:
**26.08.2009 Bulletin 2009/35**

(73) Proprietor: **Nitto Denko Corporation**
**Ibaraki-shi, Osaka 567-8680 (JP)**

(72) Inventors:
- **MITSUI, Kazuma**
  **Ibaraki-shi**
  **Osaka 567-8680 (JP)**
- **AMANO, Tatsumi**
  **Ibaraki-shi**
  **Osaka 567-8680 (JP)**
- **YONEZAKI, Kousuke**
  **Ibaraki-shi**
  **Osaka 567-8680 (JP)**
- **SUTOU, Takeshi**
  **Ibaraki-shi**
  **Osaka 567-8680 (JP)**
- **TAKASHIMA, Atsushi**
  **Ibaraki-shi**
  **Osaka 567-8680 (JP)**
- **OKUMURA, Kazuhito**
  **Ibaraki-shi**
  **Osaka 567-8680 (JP)**

(74) Representative: **TBK**
**Bavariaring 4-6**
**80336 München (DE)**

(56) References cited:
**WO-A1-2006/104133 JP-A- 2003 282 489**
**JP-A- 2005 228 856 JP-A- 2006 316 208**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 093 268 B1

## Description

### TECHNICAL FIELD

The present invention relates to use of a removable pressure-sensitive adhesive sheet, and an optical member, wherein a surface of the optical member is protected by a removable pressure-sensitive adhesive sheet having antistatic property. The removable pressure-sensitive adhesive sheet include, for example, masking tapes such as masking tapes for building curing, masking tapes for automobile painting, masking tapes for electronic components (for example, lead frames and printed boards), and masking tapes for sandblasting; surface-protective films such as surface-protective films for aluminum sashes, surface-protective films for optical plastics, surface-protective films for optical glass products, surface-protective films for automobile protection, and surface-protective films for metal plates; adhesive tapes for use in semiconductor and electronic component processes, such as back grinding tapes, pellicle fixing tapes, dicing tapes, lead frame fixing tapes, cleaning tapes, dust removing tapes, carrier tapes, and cover tapes; tapes for packing electronic devices or electronic components; tapes for temporary bonding during transportation; binding tapes; and labels. The removable pressure-sensitive adhesive sheet used in the present invention is particularly useful as a protective film for optical members such as a polarizing plate and a wavelength plate used in panels requiring transparency, such as liquid crystal displays, organic EL electroluminescence displays and field emission displays.

### BACKGROUND ART

In the steps of manufacturing an optical sheet such as a polarizing plate and of mounting the optical sheet on another member, a surface-protective film is previously stuck on the optical sheet in order to prevent defects or pollution on the optical sheet in this operation. The optical sheet while being provided thereon with a surface-protective film is examined for its defects and the like, so that as a base material of the protective film, a highly transparent base material such as polyester film is used (see, for example, Patent Documents 1 to 5).

Conventionally, such film is provided with an antistatic layer for preventing charging by friction or detachment, then a pressure-sensitive agent is applied thereon and dried, a releasable film is stuck thereon, and generally the film is cut into sheets in conformity with the objective polarization angle and phase angle, and a predetermined number of sheets are laminated on one another and then stored (see, for example, Patent Document 6).

In the operation of cutting the surface-protective film into sheets, a pressure-sensitive adhesive stuck out from the cut face of one sheet not only adheres to the surface of another sheet of the protective film to hinder product inspection but is also sticky to cause disadvantage in shipping of sheets as the product. Accordingly, a surface-protective film provided with an antifouling layer on one side thereof has been proposed (see, for example, Patent Document 7) . However, this means was revealed to increase the number of production steps, thus increasing costs.

Patent Document 1: JP-A 07-311160
Patent Document 2: JP-A 2003-089178
Patent Document 3: JP-A 2005-002220
Patent Document 4: JP-A 2005-125659
Patent Document 5: JP-A 2004-094012
Patent Document 6: JP-A 2001-096698
Patent Document 7: JP-A 11-256115

JP2005228856 (A) discloses a film that is formed of at least two layers of a layer A formed of blended resin of 40 to 75 mass% of polypropylene system resin or polyethylene system resin, and hydrophilic polyethylene resin or hydrophilic polypropylene resin, in which a polyoxy alkylene chain is block-bonded to 60 to 25 mass% of a polyethylene chain or a polypropylene chain and of a layer B formed of polyethylene system resin. An additional layer B1, by polyethylene system resin of one layer, is laminated and smoothness to a dicing pedestal is further improved.

JP2003282489 (A) discloses an adhesive sheet used for processing a semiconductors in which an adhesive agent layer comprising a base polymer, a radiation polymerizable chemical agent and a radiation polymerization starting agent is applied to a substrate surface pervious with respect to an ultraviolet ray and/or an electron beam, wherein an antistatic effect is obtained and an electrostatic-charged voltage does not exceed 200 V in the adhesive surface of the sheet when a film for exfoliation has been exfoliated.

## DISCLOSURE OF THE INVENTION

## PROBLEMS TO BE SOLVED BY THE INVENTION

In view of these circumstances, the present invention is to provide use of an inexpensive surface-protective film for protecting a surface of an optical member, which is excellent in the ability to protect an adherend (in particular, an optical member such as an optical sheet) so that an adherend (inparticular, an optical sheet) on which the surface-protective film (pressure-sensitive adhesive sheet) has been stuck can be inspected highly accurately for defects. The present invention is to provide said use of an inexpensive surface-protective film which prevents an adherend (in particular, an optical sheet) frombeing electrostatically charged during the processing or transportation of the adherend (in particular, an optical sheet), and has the function of preventing fouling, and to provide an optical member.

## MEANS FOR SOLVING THE PROBLEMS

The present inventors have made extensive study to overcome the disadvantages described above, and as a result, they have found that the objects described above can be achieved by the use according to claim 1, and the optical member according to claim 10, thereby completing the present invention. Further beneficial embodiments are disclosed in dependent claims 2 to 9.

The pressure-sensitive adhesive sheet used in the present invention is a removable pressure-sensitive adhesive sheet which is provided on one side of a base material layer with a pressure-sensitive adhesive layer and on the other side thereof with an antistatic layer, wherein the antistatic layer includes a polymeric antistatic agent consisting of an olefin block and a hydrophilic block.

As shown in the results in Examples, according to the present invention, the pressure-sensitive adhesive sheet having an antistatic layer containing a polymeric antistatic agent consisting of an olefin block and a hydrophilic block serves as an inexpensive surface-protective film which is excellent in the ability to protect an adherend (in particular, an optical member such as an optical sheet) so that an adherend (in particular, an optical sheet) on which the surface-protective film (pressure-sensitive adhesive sheet) has been stuck can be inspected highly accurately for defects, and which prevents an adherend (in particular, an optical sheet) from being electrostatically charged during the processing or transportation of the adherend (in particular, an optical sheet), and has the function of preventing fouling. The reason that the pressure-sensitive adhesive sheet exhibits such characteristics is not evident, and it is estimated that by using an antistatic layer with a polymeric antistatic agent consisting of the specific composition described above, the sheet is not made sticky, does not disturb product inspection, is made excellent in adhesion reliability and transparency, and can be inexpensively produced. By using the polymeric antistatic agent in the antistatic layer, the antistatic performance of the pressure-sensitive adhesive sheet is hardly deteriorated even by treatment such as washing with water or wiping with a cloth dampened with water and can attain stable antistatic performance.

The pressure-sensitive adhesive sheet is **characterized in that** the antistatic layer contains a polymeric antistatic agent consisting of an olefin block and a hydrophilic block.

The polymeric antistatic agent in the present invention is a block copolymer having an olefin block and a hydrophilic block, wherein the olefin block and hydrophilic block are bound chemically to each other.

In the present invention, the antistatic layer preferably contains a propylene resin. The antistatic layer preferably contains a propylene homopolymer and/or a propylene/$\alpha$-olefin random copolymer. The antistatic layer can be a layer containing a propylene/$\alpha$-olefin random copolymer polymerized by using a metallocene catalyst.

The base material layer preferably consists of a propylene resin, and more preferably consists of a propylene homopolymer and/or a propylene/$\alpha$-olefin random copolymer. The base material layer may consist of a propylene/$\alpha$-olefin random copolymer polymerized by using a metallocene catalyst.

The pressure-sensitive adhesive layer preferably consists of a (meth) acrylic polymer mainly based on one or more acrylates and/or methacrylates having an alkyl group containing 1 to 14 carbon atoms. The pressure-sensitive adhesive layer is preferably a crosslinked structure obtained by crosslinking the (meth) acrylic polymer.

The pressure-sensitive adhesive sheet used in the present invention has the above-described working effect and is thus used for protecting the surface of an optical member.

## BEST MODE FOR CARRYING OUT THE INVENTION

Hereinafter, embodiments of the invention are described in detail.

The pressure-sensitive adhesive sheet used in the present invention is a removable pressure-sensitive adhesive sheet which is provided on one side of a base material layer with a pressure-sensitive adhesive layer and on the other side thereof with an antistatic layer, wherein the antistatic layer contains a polymeric antistatic agent consisting of an olefin block and a hydrophilic block.

The material used in the base material layer is not particularly limited as long as it is a plastic giving a highly transparent pressure-sensitive adhesive sheet, and examples include transparent resins such as polypropylene, polyester, polycarbonate,polyamide,polyimide,polyacrylate,polystyrene, polyacetate, polyethersulfone and triacetyl cellulose. Among them, polypropylene is used preferably from the viewpoint of productivity and moldability. These resins may be used singly or as a mixture of two or more thereof.

The polypropylene includes a homo type that is a homopolymer, a random type that is a propylene/α-olefin random copolymer, and a block type that is a propylene/α-olefin block copolymer, and particularly a homo or random type is preferably used because it can give a highly transparent pressure-sensitive adhesive sheet. As used herein, the term "highly transparent" refers to 88% or more, preferably 90% or more, more preferably 92% or more, in terms of total-light transmittance defined by JIS K7361, and simultaneously to 9% or less, preferably 8% or less, more preferably 7% or less, even more preferably less than 5%, in terms of haze defined by JIS K7136. Such polypropylene polymers may be used alone or as a mixture of two or more thereof.

The homo type of polypropylene can be used without particular limitation as long as it is a resin capable of giving the objective highly transparent pressure-sensitive adhesive sheet. Commercial products of such resin include, for example, ZS1327A, F104A, F3900, J-5900 (all manufactured by Prime Polymer Co., Ltd.), and the like.

The α-olefin component in the random type of propylene/α-olefin random copolymer includes, for example, ethylene, 1-butene, 1-pentene, 1-hexene, 1-heptene, 1-octene, 3-methylbutene-1, 4-methylpentene-1, and 3-methylhexene-1, among which ethylene, 1-butene, 3-methylbutene-1, and 4-methylpentene-1 are preferable. Besides, nonconjugated dienes such as 4-methyl-1, 4-hexadiene, 5-methyl-1, 4-hexadiene, 7-methyl-1, 6-octadiene, and 1, 9-decadiene can be used as a part of the polymer component. Cyclic olefins such as norbornene can also be polymerized.

The random copolymer includes, for example, a propylene/ethylene random copolymer, a propylene/1-butene random copolymer, a propylene/1-hexene random copolymer, a propylene/ethylene/1-octene random copolymer, and a propylene/ethylene/1-butene random copolymer. Commercial products include, for example, F327, J-5910, J-5710 (all manufactured by Prime Polymer Co., Ltd.), WINTEC WFX6, WINTEC WFX4, WINTEC WFX4T, WINTEC WFX4TA, WINTEC WFW4 (all manufactured by Japan Polypropylene Corporation), and the like. Among them, the propylene/α-olefin random copolymer polymerized by using a metallocene catalyst is preferably used because it can give a film having more excellent transparency. The propylene/α-olefin random copolymer polymerized by using a metallocene catalyst is preferably used because it can become a copolymer having a uniform composition to give a highly transparent base material layer.

α-Olefins used in the propylene/α-olefin random copolymer polymerizedby using a metallocene catalyst include, for example, ethylene, 1-butene, 1-pentene, 1-hexene, 1-heptene, 1-octene, 3-methylbutene-1, 4-methylpentene-1, and 3-methylhexene-1, among which ethylene, 1-butene, 3-methylbutene-1, and 4-methylpentene-1 are preferable. Besides, nonconjugated dienes such as 4-methyl-1, 4-hexadiene, 5-methyl-1, 4-hexadiene, 7-methyl-1, 6-octadiene, and 1, 9-decadiene can be used as a part of the polymer component. Cyclic olefins such as norbornene can also be copolymerized. Specific examples of the random copolymer include a propylene/ethylene random copolymer, a propylene/1-butene random copolymer, a propylene/1-hexene random copolymer, a propylene/ethylene/1-octene random copolymer, and a propylene/ethylene/1-butene random copolymer.

As the propylene/α-olefin random copolymer polymerized by using a metallocene catalyst, the copolymer having a melting point of 110°C to 150°C, particularly 110°C to 135°C, is preferably used from the viewpoint of moldability. Specific examples include commercial products such as WINTEC WFX6, WINTEC WFX4, WINTEC WFX4T, WINTEC WFX4TA, and WINTEC WFW4 (all manufactured by Japan Polypropylene Corporation). The melting point herein refers to a value determined from a melting peak temperature by a differential scanning calorimeter.

The metallocene catalyst as used herein is a catalyst consisting of a transition metal compound (so-called a metallocene compound) in Group IV in the periodic table, containing a ligand having a cyclopentadienyl skeleton, a co-catalyst which can be activated into a stable ionic state by reacting with a metallocene compound, and if necessary an organoaluminum compound, and any known catalyst can be used. The metallocene compound is preferably a crosslinkedmetallocene compound capable of stereoregular polymerization of propylene, more preferably a crosslinked metallocene compound capable of polymerization with isotactic regularity.

The metallocene compounds are disclosed in, for example, JP-A 60-35007, JP-A 61-130314, JP-A 63-295607, JP-A 1-275609, JP-A 2-41303, JP-A 2-131488, JP-A 2-76887, JP-A 3-163088, JP-A 4-300887, JP-A 4-211694, JP-A 5-43616, JP-A 5-209013, JP-A 6-239914, Japanese Patent Application National Publication (Laid-Open) No. 7-504934, and JP-A 8-85708.

Specific examples of the metallocene compounds include zirconium compounds such as methylene(cyclopentadienyl) (3,4-dimethylcyclopentadienyl) zirconium dichloride, isopropylidene (cyclopentadienyl) (3,4-dimethylcyclopentadienyl) zirconium dichloride, ethylene (cyclopentadienyl) (3,5-dimethylpentadienyl) zirconium dichloride, methylenebis(indenyl) zirconium dichloride, ethylenebis(2-methylindenyl) zirconium dichloride, ethylene 1,2-bis(4-phenylindenyl) zirconium dichloride, isopropylidene (cyclopentadienyl) (fluorenyl) zirconium dichloride, isopropylidene (4-methylcyclopentadienyl) (3-t-butylindenyl) zirconium dichloride, dimethylsilylene(cyclopentadienyl) (tetramethylcyclopentadienyl)

zirconium dichloride, dimethylsilylenebis(indenyl) zirconium dichloride, dimethylsilylenebis(4,5,6,7-tetrahydroindenyl) zirconium dichloride, dimethylsilylene(cyclopentadienyl) (fluorenyl) zirconium dichloride, dimethylsilylene(cyclopentadienyl) (octahydrofluorenyl) zirconium dichloride, dimethylsilylenebis[4-(1-phenyl-3-methylindenyl)] zirconium dichloride, dimethylsilylene(fluorenyl) t-butylamide zirconium dichloride, methylphenylsilylenebis[1-(2-methyl-4,5-benzoindenyl)] zirconium dichloride, dimethylsilylenebis[1-(2-methyl-4,5-benzoindenyl)] zirconium dichloride, dimethylsilylenebis[1-(2-methyl-4-phenyl-4H-azulenyl)] zirconium dichloride, dimethylsilylenebis[1-(2-methyl-4-(4-chlorophenyl)-4H-azule nyl)] zirconium dichloride, dimethylsilylenebis[1-(2-ethyl-4-(4-chlorophenyl)-4H-azulen yl)] zirconium dichloride, dimethylsilylenebis[1-(2-ethyl-4-naphthyl-4H-azulenyl)] zirconium dichloride, diphenylsilylenebis[1-(2-methyl-4-(4-chlorophenyl)-4H-azule nyl)] zirconium dichloride, dimethylsilylenebis[1-(2-methyl-4-phenylindenyl)] zirconium dichloride, dimethylsilylenebis[1-(2-ethyl-4-phenylindenyl)] zirconium dichloride, dimethylsilylenebis[1-(2-ethyl-4-naphthyl-4H-azulenyl)] zirconium dichloride, dimethylgermylenebis(indenyl) zirconium dichloride, and dimethylgermylene(cyclopentadienyl) (fluorenyl) zirconium dichloride. In the above description, the compounds wherein zirconium was replaced by titanium or hafnium can also be similarly used. Depending on the case, a mixture of the zirconium compound, the hafnium compound, and the like can also be used. The chloride may be replaced by another halogen compound, a hydrocarbon group such as methyl, isobutyl or benzyl, an amide group such as dimethylamide or diethylamide, an alkoxide group such as a methoxy group or a phenoxy group, or a hydride group.

The metallocene compound may be supported by a carrier of an organic or inorganic compound. The carrier is preferably a porous organic or inorganic compound, and specific examples include ion-exchangeable layer silicates, inorganic compounds such as zeolite, $SiO_2$, $Al_2O_3$, silica alumina, MgO, $ZrO_2$, $TiO_2$, $B_2O_3$, CaO, ZnO, BaO, and $ThO_2$, and organic compounds consisting of porous polyolefin, a styrene/divinylbenzene copolymer, an olefin/acrylic acid copolymer or the like, or mixtures thereof.

A co-catalyst which can be activated into a stable ionic state by reacting with the metallocene compound includes, for example, organoaluminumoxy compounds (for example, aluminoxane compounds), ion-exchangeable layer silicates, Lewis acids, boron-containing compounds, ionic compounds, and fluorine-containing organic compounds.

The organoaluminum compounds include, for example, trialkyl aluminum such as triethyl aluminum, triisopropyl aluminum and triisobutyl aluminum, and dialkyl aluminum halide, alkyl aluminum sesquihalide, alkyl aluminum dihalide, alkyl aluminum halide, and organic aluminum alkoxide.

The polymerizationmethod includes a slurrymethod of using an inert solvent, a solution method, a gaseous phase method of not substantially using a solvent, and a bulk polymerization method of using a polymerizable monomer as a solvent, in the presence of the catalyst. The method of obtaining the propylene/$\alpha$-olefin copolymer involves, for example, regulating the polymerization temperature and the amount of comonomers to appropriately regulate molecular-weight and crystalline distribution, whereby the desired polymer can be obtained.

The resins used in the base material layer can be used alone or as a mixture of two or more thereof. The base material layer may be composed of either a single layer or two or more layers formed from different resin layers. The thickness of the base material layer is generally 10 to 200 $\mu$m, preferably 20 to 100 $\mu$m, more preferably 30 to 70 $\mu$m.

Various additives and fillers used generally in a film base material, such as an antioxidant, a lubricant, an anti-blocking agent and an ultraviolet absorber can be added as necessary to the base material layer in such a range that the obj ect of the present invention is not impaired. The surface of the film may be subjected to easy adhesion treatment such as acid treatment, alkali treatment, primer treatment, corona treatment, plasma treatment, and ultraviolet ray treatment, if necessary.

The antistatic layer of the present invention is characterized by containing a polymeric antistatic agent, and is preferably formed from both a resin used in the base material layer and a polymeric antistatic agent.

Among the resins used in the base material layer, polypropylene is used preferably as the resin used in the antistatic layer, from the viewpoint of productivity, moldability and antifouling property.

The polypropylene includes a homo type that is a homopolymer, a random type that is a propylene/$\alpha$-olefin random copolymer, and a block type that is a propylene/$\alpha$-olefin block copolymer, and particularly a homo or random type is preferably used from the viewpoint of transparency.

The homo type of polypropylene can be used without particular limitation as long as it is a resin capable of giving the objective highly transparent pressure-sensitive adhesive sheet. Commercial products of such resin include, for example, ZS1327A, F104A, F3900, J-5900 (all manufactured by Prime Polymer Co., Ltd.), etc.

The $\alpha$-olefin component in the random type of propylene/$\alpha$-olefin copolymer includes, for example, ethylene, 1-butene, 1-pentene, 1-hexene, 1-heptene, 1-octene, 3-methylbutene-1, 4-methylpentene-1, and 3-methylhexene-1, among which ethylene, 1-butene, 3-methylbutene-1, and 4-methylpentene-1 are preferable. Besides, nonconjugated dienes such as 4-methyl-1,4-hexadiene,5-methyl-1, 4-hexadiene, 7-methyl-1, 6-octadiene, and 1, 9-decadiene can be used as a part of the polymer component. Cyclic olefins such as norbornene can also be polymerized.

The random type of propylene/$\alpha$-olefin random copolymer includes, for example, a propylene/ethylene random copolymer, a propylene/1-butene random copolymer, a propylene/1-hexene random copolymer, a propylene/ethylene/1-octene random copolymer, and a propylene/ethylene/1-butene random copolymer. Commercial products include, for

example, F327, J-5910, J-5710 (all manufactured by Prime Polymer Co., Ltd.), WINTEC WFX6, WINTEC WFX4, WINTEC WFX4T, WINTEC WFX4TA, WINTEC WFW4 (all manufactured by Japan Polypropylene Corporation), etc. Among them, the propylene/α-olefin random copolymer polymerized by using a metallocene catalyst is preferably used because it can become a copolymer having a uniform composition to give a highly transparent antistatic layer.

α-Olefins used in the propylene/α-olefin random copolymer polymerized by using a metallocene catalyst includes, for example, ethylene, 1-butene, 1-pentene, 1-hexene, 1-heptene, 1-octene, 3-methylbutene-1, 4-methylpentene-1, and 3-methylhexene-1, among which ethylene, 1-butene, 3-methylbutene-1, and 4-methylpentene-1 are preferable. Besides, nonconjugated dienes such as 4-methyl-1, 4-hexadiene, 5-methyl-1, 4-hexadiene, 7-methyl-1, 6-octadiene, and 1, 9-decadiene can be used as a part of the polymer component. Cyclic olefins such as norbornene can also be copolymerized. Specific examples of the random copolymer include a propylene/ethylene random copolymer, a propylene/1-butene random copolymer, a propylene/1-hexene random copolymer, a propylene/ethylene/1-octene random copolymer, and a propylene/ethylene/1-butene random copolymer.

As the propylene/α-olefin random copolymer polymerized by using a metallocene catalyst, the copolymer having a melting point of 110°C to 150°C, particularly 110°C to 135°C, is preferably used from the viewpoint of moldability and compatibility with the antistatic agent. Specific examples include commercial products such as WINTEC WFX6, WINTEC WFX4, WINTEC WFX4T, WINTEC WFX4TA, WINTEC WFW4 (all manufactured by Japan Polypropylene Corporation) etc.

The polymeric antistatic agent used in the present invention is a block copolymer having an olefin block and a hydrophilic block. The olefin block in the block copolymer plays a function of uniform dispersion into a resin forming the antistatic layer, and the hydrophilic block plays an antistatic function. Accordingly, the copolymer containing both the components can form a highly transparent antistatic layer which uniformly disperses the antistatic agent in the antistatic layer and can exhibit stable antistatic performance. By using the antistatic agent consisting of the block copolymer, stable antistatic performance can be achieved with less reduction in antistatic performance, even upon treatment such as washing with water or wiping with a cloth dampened with water.

The olefin block forming the block copolymer is an α-olefin (co)polymer. The α-olefin (A1) used herein includes, for example, ethylene, propylene, 1-butene, 1-pentene, 1-hexene, 1-heptene, 1-octene, 3-methylbutene-1, 4-methylpentene-1, and 3-methylhexene-1, among which ethylene, propylene, 1-butene, 3-methylbutene-1, and 4-methylpentene-1 are preferable. Besides, nonconjugated dienes such as 4-methyl-1, 4-hexadiene, 5-methyl-1, 4-hexadiene, 7-methyl-1, 6-octadiene, and 1, 9-decadiene can be used as a part of the polymer component. Cyclic olefins such as norbornene can also be copolymerized. In particular, low-molecular-weight α-olefins obtained by thermal degradation of ethylene and/or propylene are preferably used.

The number-average molecular weight of α-olefins is preferably 800 to 20,000, more preferably 1,000 to 10,000, even more preferably 1,200 to 6,000. The number-average molecular weight is determined as a polystyrene-equivalent molecular weight by gel permeation chromatography (GPC).

The block copolymer is a polymer having olefin blocks chemically bound to hydrophilic blocks via at least one bond selected from an ester bond, an amide bond, an ether bond, a urethane bond and an imide bond, and has a structure wherein these blocks are bound alternately via these bonds. Accordingly, the molecular terminus of the olefin block should be denatured with a functional group having reactivity with the molecular terminal functional group of the hydrophilic block. These functional groups include a carboxylic acid group, a hydroxyl group, an amino group, an acid anhydride group, an oxazoline group, an epoxy group, and the like. Among them, a carboxylic acid group is preferable from the viewpoint of ease in denaturation.

The olefin block having a carboxylic acid group at the terminus of the polymer includes polyolefin (A2) obtained by denaturation of the terminus of the α-olefin (A1) with α,β-unsaturated carboxylic acid and/or an anhydride thereof (for example, (meth) acrylic acid, (anhydrous) maleic acid and fumaric acid; (meth)acrylic acid refers to acrylic acid and/or methacrylic acid, and (anhydrous) maleic acid refers to maleic acid and/or anhydrous maleic acid; this hereinafter applies), polyolefins obtained by secondary denaturation of the olefin (A2) with a lactam (caprolactam, laurolactam, or the like) or with aminocarboxylic acid (11-aminoundecanoic acid, 12-aminododecanoic acid, or the like), polyolefin (A3) obtained by oxidative denaturation of the α-olefin (A1) with oxygen and/or ozone, polyolefins obtained by secondary denaturation of the polyolefin (A3) with lactamor aminocarboxylic acid, and mixtures of two or more thereof.

The amount of the α,β-unsaturated carboxylic acid and/or an anhydride thereof used is 0.5 to 40% by weight, preferably 1 to 30% by weight, more preferably 2 to 20% by weight, based on the weight of α-olefin (A1), from the viewpoint of repeating structure formability and antistatic property.

The method of denaturing the α-olefin (A1) with the α,β-unsaturated carboxylic acid and/or an anhydride thereof includes a method of thermal addition (ene reaction) of α,β-unsaturated carboxylic acid and/or an anhydride thereof to the terminal double bond of the α-olefin (A1) by a solution method or a melting method. Among these methods, the solution method is preferable from the viewpoint of reaction uniformity.

The solution method includes a method wherein α,β-unsaturated carboxylic acid and/or an anhydride thereof is added to the α-olefin (A1) in a hydrocarbon solvent such as xylene or toluene and they are reacted at 170 to 230°C

in an inert gas atmosphere such as nitrogen.

The melting method includes a method wherein the α-olefin (A1) is heated and melted, then α,β-unsaturated carboxylic acid and/or an anhydride thereof is added thereto, and they are reacted at 170 to 230°C in an inert gas atmosphere such as nitrogen.

The olefin block having a hydroxyl group at the terminus of the polymer includes, for example, a polyolefin obtained by denaturing the carboxylic acid group-denatured polyolefin with C2 to C10 hydroxylamine (2-aminoethanol, 3-aminopropanol, 4-aminobutanol, 6-aminohexanol or the like), and mixtures thereof.

The denaturation with hydroxylamine can be effected for example by reacting the carboxylic acid group-denatured polyolefin directly with hydroxylamine. The reaction temperature is 120 to 230°C.

The amount of hydroxyl group in the hydroxylamine used in denaturation, in terms of the number of hydroxyl groups, is 0.1 to 2, preferably 0.3 to 1.5, more preferably 0.5 to 1.2, evenmore preferably 1, per residue of α, β-unsaturated carboxylic acid and/or an anhydride thereof in the carboxylic acid group-denatured polyolefin.

The olefin block having an amino group at the terminus of the polymer includes, for example, an amino group-denatured polyolefin obtained by denaturing the carboxylic acid group-denatured polyolefin with diamine (C2 to C18 diamine, ethylenediamine, hexamethylenediamine, heptamethylenediamine, octamethylenediamine, decamethylenediamine or the like), and mixtures thereof.

The denaturation with diamine can be effected for example by reacting the carboxylic acid group-denatured polyolefin directly with the diamine. The reaction temperature is 120 to 230°C.

The amount of amino group in the diamine used in denaturation, in terms of the number of amino groups, is 0.1 to 2, preferably 0.3 to 1.5, more preferably 0.5 to 1.2, even more preferably 1, per residue of α,β-unsaturated carboxylic acid and/or an anhydride thereof in the carboxylic acid group-denatured polyolefin.

The olefin block is obtained usually as a mixture of an olefin block denatured at both the termini and an olefin block denatured at one terminus, and the mixture may be used as it is, or may be separated and purified so that only the olefin block denatured at both the termini or only the olefin block denatured at one terminus can be used.

The number-average molecular weight of the polyolefin block is 800 to 50,000, preferably 1,000 to 30,000, more preferably 2, 000 to 20,000, even more preferably 2,500 to 10, 000.

The hydrophilic polymer in the hydrophilic block includes, for example, polyether, a polyether-containing hydrophilic polymer, a cationic polymer and an anionic polymer.

The polyether includes, for example, polyether diols, polyether diamines, and denatured products thereof.

The polyether diols include, for example, those represented by general formula (1): $H\text{-}(OA^1)n\text{-}O\text{-}E^1\text{-}O\text{-}(A^1O)n'\text{-}H$ and those represented general formula (2):

$$H\text{-}(OA^2)m\text{-}O\text{-}E^2\text{-}O\text{-}(A^2O)m'\text{-}H.$$

In the general formula (1), $E^1$ is the residue of a divalent hydroxyl group-containing compound from which a hydroxyl group was removed, $A^1$ is an alkylene group having 2 to 4 carbon atoms, and n and n' each represent the number of alkylene oxides added per hydroxyl group of the divalent hydroxyl group-containing compound. ($OA^1$), the number of which is n, and ($A^1O$), the number of which is n' , may be the same or different, and when they are composed of two or more oxyalkylene groups, the bonding form thereof may be random, block or a combination thereof.

Each of n and n' is usually 1 to 300, preferably 2 to 250, more preferably 10 to 100. n and n' may be the same or different.

The divalent hydroxyl group-containing compound includes, for example, compounds containing 2 alcoholic or phenolic hydroxyl groups in one molecule, that is, dihydroxy compounds. Specific examples include dihydric alcohols (for example, aliphatic, alicyclic or aromatic dihydric alcohols having 2 to 12 carbon atoms), dihydric phenols having 6 to 18 carbon atoms, and tertiary amino group-containing diols.

The aliphatic dihydric alcohol includes, for example, alkylene glycols such as ethylene glycol and propylene glycol, 1,4-butanediol, 1,6-hexanediol, neopentyl glycol, and 1,12-dodecanediol.

The alicyclic dihydric alcohol includes, for example, 1,2- and 1, 3-cyclopentanediol, 1,2-, 1,3- and 1,4-cyclohexanediol, and 1,4-cyclohexanedimethanol, and the aromatic dihydric alcohol includes, for example, xylenediol and the like.

The dihydric phenol includes, for example, monocyclic dihydric phenols such as hydroquinone, catechol, resorcin and urushiol, bisphenols such as bisphenol A, bisphenol F, bisphenol S, 4,4'-dihydroxydiphenyl-2,2-butane, dihydroxy biphenyl, and dihydroxy diphenyl ether, and condensed polycyclic dihydric phenols such as dihydroxynaphthalene and binaphthol.

In the general formula (2), E2 represents the residue of the divalent hydroxyl group-containing compound of the general formula (1) from which a hydroxyl group was removed, $A^2$ is a substituted alkylene group, at least a part of which is represented by the general formula (3) : -CHR-CHR'- [wherein one of R and R' is a group represented by the general formula (4) : $-CH_2O(A^3O)_xR''$, and the other is H, wherein X represents an integer of 1 to 10, R" represents H or an alkyl group, an aryl group, an alkylaryl group, an arylalkyl group or an acyl group having 1 to 10 carbon atoms,

and $A^3$ represents an alkylene group having 2 to 4 carbon atoms], and the other may be an alkylene group having 2 to 4 carbon atoms.

$(OA^2)$, the number of which is m, and $(A^2O)$, the number of which is m', may be the same or different. Each of m and m' is preferably 1 to 300, more preferably 2 to 250, even more preferably 10 to 100. m and m' may be the same or different.

The polyether diol represented by the general formula (1) can be produced by addition reaction of alkylene oxide with the divalent hydroxyl group-containing compound.

The alkylene oxide includes, for example, C2 to C4 alkylene oxides such as ethylene oxide, propylene oxide, 1,2-butylene oxide, 1,4-butylene oxide, 2, 3-butylene oxide and 1, 3-butylene oxide, and a combination of two or more thereof.

When two or more alkylene oxides are simultaneously used, the binding form thereof may be random and/or block. The alkylene oxide is preferably ethylene oxide alone or ethylene oxide to which another alkylene oxide is added in a block and/or random form.

The number of alkylene oxides added per hydroxyl group of the divalent hydroxyl group-containing compound is preferably 1 to 300, more preferably 2 to 250, even more preferably 10 to 100. A preferable method of producing the polyether diol represented by the general formula (2) includes the following methods (A) and (B).

(A) A method wherein the polyether diol is produced by polymerizing, as a starting material, the divalent hydroxyl group-containing compound with glycidyl ether represented by the general formula (5):

[Formula 1]

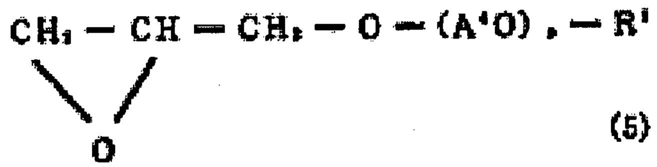

(5)

wherein $A^4$ represents an alkylene group having 2 to 4 carbon atoms, p represents an integer of 1 to 10, and $R^1$ represents Horanalkylgroup, an aryl group, an alkylaryl group, an arylalkyl group or an acyl group having 1 to 10 carbon atoms, or by copolymerizing the divalent hydroxyl group-containing compound with an alkylene oxide having 2 to 4 carbon atoms.

(B) A method wherein the polyether diol is produced via a polyether having a chloromethyl group in a side chain from the divalent hydroxyl group-containing compound as a starting material.

More specifically, epichlorohydrin, or epichlorohydrin is subjected to addition copolymerization with alkylene oxide to give a polyether having a chloromethyl group in a side chain, and then the polyether is reacted with C2 to C4 polyalkylene glycol and $R^1X$ (wherein $R^1$ is as defined above and X represents Cl, Br or I) in the presence of an alkali, or the polyether is reacted with C2 to C4 polyalkylene glycol monocarbyl ether in the presence of an alkali. The C2 to C4 alkylene oxide used herein includes the alkylene oxides described above.

The polyether diamine can be obtained by changing a hydroxyl group of the polyether diol into an amino group by a method known in the art. The polyether diamine includes, for example, that which is obtained by cyanoalkylating a hydroxyl group of the polyether diol and reducing the resulting terminus to form an amino group.

The denatured product includes an aminocarboxylic acid denatured product (with an amino acid at the terminus) of the polyether diol or polyether diamine, an isocyanate denatured product (with an isocyanate group at the terminus) of the polyether diol or polyether diamine, and an epoxy denatured product (with an epoxy group at the terminus) of the polyether diol or polyether diamine.

The aminocarboxylic acid denatured product is obtained by reacting the polyether diol or polyether diamine with an aminocarboxylic acid or lactam.

The isocyanate denatured product is obtained by reacting the polyether diol or polyether diamine with an organic diisocyanate or by reacting the polyether diamine with phosgene.

The organic diisocyanate includes an aromatic diisocyanate having 6 to 20 carbon atoms (excluding carbon atoms in the NCO group; this hereinafter applies), an aliphatic diisocyanate having 2 to 18 carbon atoms, an alicyclic diisocyanate having 4 to 15 carbon atoms, an aromatic aliphatic diisocyanate having 8 to 15 carbon atoms, denatured products of these diisocyanates, and mixtures of two or more thereof.

The epoxy denatured product is obtained by reacting the polyether diol or polyether diamine with a diepoxide (diglycidyl ether, diglycidyl ester, and epoxy resin such as alicyclic diepoxide, epoxy equivalent: 85 to 600) or by reacting

polyether diol with epihalohydrin (epichlorohydrin or the like).

The number-average molecular weight of the polyether is 150 to 20,000, preferably 300 to 20,000, more preferably 1,000 to 15,000, even more preferably 1,200 to 8,000.

The polyether-containing hydrophilic polymer includes, for example, a polyether ester amide having a segment of polyether diol, a polyether amide imide having a segment of polyether diol, a polyether ester having a segment of polyether diol, a polyether amide having a segment of polyether diamine, and a polyether urethane having a segment of polyether diol or polyether diamine.

The polyether ester amide is composed of a polyamide having a carboxyl group at the terminus and the polyether diol.

The polyamide includes, for example, a lactam ring-opened polymer having 6 to 12 carbon atoms, an aminocarboxylic acid polycondensate having 6 to 12 carbon atoms, and an amide between a diamine (an aliphatic diamine having 2 to 20 carbon atoms, an alicyclic diamine having 6 to 15 carbon atoms, an aromatic diamine having 8 to 15 carbon atoms, or the like) and a dicarboxylic acid having 4 to 20 carbon atoms (an aliphatic dicarboxylic acid, an aromatic dicarboxylic acid, an alicyclic dicarboxylic acid and an ester-forming derivative thereof (a lower alkyl (C1 to C6) ester, an anhydride or the like)), and mixtures thereof.

As the polyamide, a caprolactam ring-opened polymer, a polycondensate of 12-aminododecanoic acid, and an amide between adipic acid and hexamethylene diamine are preferably used, and the caprolactam ring-opened polymer is particularly preferably used.

The polyether amide imide is composed of a polyamide imide having at least one imide ring and the polyether diol.

Examples of the polyamide imide that is used herein include a polymer consisting of a lactam having 6 to 12 carbon atoms and a trivalent or tetravalent aromatic polycarboxylic acid capable of forming at least one imide ring, a polymer consisting of an aminocarboxylic acid having 6 to 12 carbon atoms and a trivalent or tetravalent aromatic polycarboxylic acid, a polymer consisting of a diamine (an aliphatic diamine having 2 to 20 carbon atoms, an alicyclic diamine having 6 to 15 carbon atoms, an aromatic diamine having 8 to 15 carbon atom, or the like), a dicarboxylic acid having 4 to 20 carbon atoms (an aliphatic dicarboxylic acid, an aromatic dicarboxylic acid, an alicyclic dicarboxylic acid and an ester-forming derivative thereof (a lower alkyl (C1 to C6) ester, an anhydride or the like)) and a trivalent or tetravalent aromatic polycarboxylic acid, and mixtures thereof.

The polyether ester is composed of a polyester and the polyether diol. The polyester includes a polyester consisting of a dicarboxylic acid having 4 to 20 carbon atoms and a diol (for example, an aliphatic group, alicyclic or aromatic dihydric alcohol having 2 to 12 carbon atoms, a dihydric phenol having 6 to 18 carbon atoms, a tertiary amino group-containing diol, or the like), a polyester consisting of a lactone having 6 to 12 carbon atoms and an oxycarboxylic acid having 6 to 12 carbon atoms, and mixtures thereof.

The polyether amide is composed of the polyamide and the polyether diamine.

The polyether urethane is composed of the organic diisocyanate and the polyether diol or the polyether diamine and if necessary a chain extender (dihydric alcohol among the above-described diols, the diamine, or the like).

From the viewpoint of moldability, the content of the polyether segment in the polyether-containing hydrophilic polymer is 30 to 80% by weight, preferably 40 to 70% by weight, based on the weight of the polyether-containing hydrophilic polymer.

From the viewpoint of antistatic property and moldability, the content of the oxyalkylene group in the polyether-containing hydrophilic polymer is 30 to 80% by weight, preferably 40 to 70% by weight, based on the weight of the polyether-containing hydrophilic polymer.

The number-average molecular weight of the polyether-containing hydrophilic polymer is 800 or more, preferably 1, 000 or more, from the viewpoint of heat resistance, and is 50,000 or less, preferably 30,000 or less, from the viewpoint of reactivity with the olefin block.

As the cationic polymer, a polymer having, in its molecule, 2 to 80, preferably 3 to 60, cationic groups separated from one another by a nonionic molecular chain is used.

The nonionic molecular chain is a divalent organic group such as at least one divalent hydrocarbon group selected from the group consisting of a divalent hydrocarbon group, a hydrocarbon group having an ether bond, a thioether bond, a carbonyl group, an ester bond, an imino bond, an amide bond, an imide bond, a urethane bond, an urea bond, a carbonate bond and/or a siloxy bond, and a hydrocarbon group having a heterocyclic structure containing a nitrogen atom or an oxygen atom, or a combination of two or more thereof.

The divalent hydrocarbon group includes a linear or branched aliphatic hydrocarbon group having 1 to 8 carbon atoms, an aromatic hydrocarbon group having 6 to 20 carbon atoms, and an alicyclic hydrocarbon group having 4 to 15 carbon atoms.

The divalent hydrocarbon group having an ether bond, a thioether bond, a carbonyl group, an ester bond, an imino bond, an amide bond, an imide bond, a urethane bond, an urea bond, a carbonate bond and/or a siloxy bond includes a (poly) oxyalkylene group, a residue of polyether diol, a residue of monoether diol, a residue of polythioether, a residue of polyester, a residue of polyamide, a residue of polyurethane, a residue of polyurea, a residue of polycarbonate,

and a residue of polyorganosiloxane. Among them, a divalent hydrocarbon group and a divalent hydrocarbon group having an ether bond are preferable, and an alkylene group having 1 to 8 carbon atoms, a phenylene group, a (poly)oxyethylene group, and a (poly) oxypropylene group are preferable as the nonionic polymer chain.

The number-average molecular weight of the nonionic molecular chain is 28 to 10,000, preferably 300 to 5,000.

The cationic group includes a group having a quaternary ammonium salt or a phosphonium salt. The group having a quaternary ammonium salt is preferably a divalent quaternary ammonium salt-containing heterocyclic group.

The divalent quaternary ammonium salt-containing heterocyclic group includes quaternarized products of divalent tertiary amino group-containing heterocyclic groups [for example, divalent imidazole cyclic groups (1,4-imidazolene group, 2-phenyl-1,4-imidazolene group, and the like), divalent piperidine cyclic groups (2,3-piperidylene group, 3, 4-piperidylene group, 2, 6-piperidylene group, and the like), and divalent aromatic heterocyclic groups (2, 3-pyridylene group, 2,4-pyridylene group, 2,5-pyridylene group, 2,6-pyridylene group, 3,4-pyridylene group, 3,5-pyridylene group, 2,5-pyrimidinylene group, 3,6-pyridazinylene group, 2,5-pyrazinylene group, and the like)].

Counter anions of the cationic groups include super strong acid anions and other anions. The super strong acid anions include anions of super strong acids (tetrafluoroboric acid, hexafluorophosphoric acid, and the like) derived from a combination of protonic acid and Lewis acid, as well as super strong acids such as trifluoromethanesulfonic acid. Other anions include halogen ions ($F^-$, $Cl^-$, $Br^-$, $I^-$), $OH^-$, $PO_4^-$, $ClO_4^-$, $NO_3^-$, $CH_3COO^-$, $C_2H_5OSO_4^-$, and $CH_3OSO_4^-$.

From the viewpoint of reactivity with the olefin block, the terminal structure of the cationic polymer is preferably a carbonyl group, a hydroxyl group or an amino group.

The number-average molecular weight of the cationic polymer is 500 to 20,000, preferably 1,000 to 15,000, more preferably 1,200 to 8,000.

The anionic polymer includes an anionic polymer having a dicarboxylic acid having a sulfonyl group, and a diol or a polyether, as essential structural units and having, in one molecule, 2 to 80, preferably 3 to 60, sulfonyl groups.

The dicarboxylic acid having a sulfonyl group includes an aromatic dicarboxylic acid having a sulfonyl group, an aliphatic dicarboxylic acid having a sulfonyl group, and a dicarboxylic acid having a sulfonyl group only in the form of a salt. Among them, an aromatic dicarboxylic acid having a sulfonyl group is preferably used.

The aromatic dicarboxylic acid having a sulfonyl group includes, for example, 2-sulfoisophthalic acid, 4-sulfoisophthalic acid, 5-sulfoisophthalic acid, 4-sulfo-2,6-naphthalenedicarboxylic acid, and ester derivatives thereof (lower alkyl (C1 to C4) esters, acid anhydrides, and the like).

The aliphatic dicarboxylic acid having a sulfonyl group includes,for example, sulfosuccinic acid and ester derivatives thereof.

The dicarboxylic acid having a sulfonyl group only in the form of a salt includes alkali metal salts, alkaline earth metal salts, ammonium salts, amine salts such as mono-, di-, or triamines having a hydroxyalkyl (C2 to C4) group, quaternary ammonium salts of these amines, and a combination of two or more thereof.

The diol or polyether constituting the anionic polymer is preferably an alkane diol having 2 to 10 carbon atoms, ethylene glycol, polyethylene glycol (polymerization degree 2 to 20), an ethylene oxide adduct of bisphenol (number of moles of ethylene oxide added: 2 to 60), and a mixture of two or more thereof.

The number-average molecular weight of the anionic polymer is 500 to 20,000, preferably 1,000 to 15,000, more preferably 1,200 to 8,000.

The polymeric antistatic agent of the present invention can be obtained by polymerizing the polyolefin block with the hydrophilic polymer block by a method known in the art. The polymeric antistatic agent can be obtained for example by polymerization reaction of the olefin block with the hydrophilic block under reduced pressure at 200 to 250°C.

In the polymerization reaction, a known polymerization catalyst can be used and is preferably one kind of catalyst, or a combination of two or more catalysts, selected from tin catalysts such as monobutyl tin oxide, antimony catalysts such as antimony trioxide and antimony dioxide, titanium catalysts such as tetrabutyl titanate, zirconium catalysts such as zirconium hydroxide, zirconium oxide and zirconium acetate, and Group IIB organic acid salt catalysts.

From the viewpoint of antistatic property, the number-average molecular weight of the block copolymer consisting of the olefin block and hydrophilic block is 2,000 to 60,000, preferably 5,000 to 40,000, more preferably 8,000 to 30,000.

The content of the hydrophilic block constituting the block copolymer is preferably 10 to 90% by weight, more preferably 20 to 80% by weight, even more preferably 30 to 70% by weight, based on the weight of the block copolymer.

Such block copolymers can be produced by those methods described in, for example, JP-A 2001-278985 and JP-A 2003-48990, and the antistatic agents of the present invention are available as Pelestat 300 series, that is, Pelestat 300, 303 and 230 (trade name) manufactured by Sanyo Chemical Industries, Ltd.

The amount of the polymeric antistatic agent of the present invention used is 1 to 50% by weight, preferably 3 to 40% by weight, more preferably 5 to 35% by weight, even more preferably 10 to 30% by weight, based on the total weight of the resin and the antistatic agent constituting the antistatic layer. When the amount is lower than 1% by weight, the antistatic property is liable to be inferior, while when the amount is higher than 50% by weight, the transparency of the resulting film is liable to deterioration.

The method of mixing the synthetic resin with the antistatic agent is not particularly limited. The method includes, for example, 1) a method wherein the resin and the antistatic agent are dry-blended by a tumble mixer, a ribbon blender or a Henschel mixer, 2) a method wherein the resin and the antistatic agent are dry-blended and then melt-mixed by an extruder to form pellets, and 3) a method wherein a master batch of the resin and the antistatic agent is previously prepared, and the master batch, a resin and if necessary other additives are dry-blended and mixed by the mixer mentioned above.

From the viewpoint of further improving the antistatic property intended by the present invention, an alkali metal salt and an alkaline earth metal salt can be contained. These components can be contained before, during or after polymerization of the polymeric antistatic agent, may be compounded when the antistatic layer of the present invention is produced, or may be contained by a combination of these methods.

The alkalimetal and/or alkaline earthmetal salts include, for example, salts of organic acids, sulfonic acids, inorganic acids and halides with alkali metals such as lithium, sodium and potassium and/or alkaline earth metal salts such as magnesium and calcium.

More specific examples of the alkali metal and/or alkaline earth metal salts include alkali metal halides such as lithium chloride, sodium chloride, potassium chloride, lithium bromide, sodium bromide, and potassium bromide; alkali metal inorganic acid salts such as lithium perchlorate, sodium perchlorate, and potassium perchlorate, alkali metal organic acid salts such as potassium acetate and lithium stearate; alkali metal salts of alkylsulfonic acids having a C8 to C24 alkyl group, such as octylsulfonic acid, dodecylsulfonic acid, tetradecylsulfonic acid, stearylsulfonic acid, tetracosylsulfonic acid, and 2-ethylhexylsulfonic acid; alkali metal salts of aromatic sulfonic acids, such as phenyl sulfonic acid and naphthyl sulfonic acid; alkali metal salts of alkylbenzene sulfonic acids having a C6 to C18 alkyl group, such as octylphenyl sulfonic acid, dodecylphenyl sulfonic acid, dibutylphenyl sulfonic acid, and dinonylphenyl sulfonic acid; alkali metal salts of alkyl naphthalene sulfonic acids having a C2 to C18 alkyl group, such as alkyl naphthalene sulfonic acids having a C2 to C18 alkyl group, such as dimethyl naphthyl sulfonic acid, diisopropyl naphthyl sulfonic acid, and dibutyl naphthyl sulfonic acid; and alkali metal salts of fluorosulfonic acids such as trifluoromethane sulfonic acid. These salts can be used alone or as a mixture of two or more thereof.

The metal salt can be used in the range of preferably 0.001 to 10% by weight, more preferably 0.01 to 5% by weight, based on the polymeric antistatic agent of the present invention.

The thickness of the antistatic layer is generally 1 to 100 μm, preferably 2 to 80 μm, more preferably 3 to 70 μm, still more preferably 5 to 50 μm, further more preferably 5 to 30 μm.

Various additives and fillers used generally in a film base material, such as an antioxidant, a lubricant, an anti-blocking agent and an ultraviolet absorber can be added as necessary to the antistatic layer in such a range that the object of the present invention is not impaired.

The film-forming method for the base material layer or the antistatic layer is not particularly limited, and known film-making methods such as an extrusion method, an inflation method and a tubular method are used. In any methods, the base material layer or the antistatic layer is formed by extruding the layer laminated with the resin through dice capable of co-extrusion, by laminating the antistatic layer on the base material layer, or by sticking the base material layer and the antistatic layer with an adhesive or an adhesive layer. The base material layer can be constituted as a two or more multilayer structure. In the present invention, film making by the co-extrusion method is preferable for exhibiting transparency.

In the co-extrusion method, the temperature of the resin forming the base material layer is for example 85 to 280°C, the temperature of the resin forming the antistatic layer is for example 85 to 230°C, and the temperature of the dice is for example 180 to 280°C in molding.

In the lamination method, for example the respective layers may be laminated and then subjected to thermopressure bonding or may be previously heated and then subjected to pressure bonding.

In the method of using an adhesive, an ethylene/vinyl acetate copolymer or a methyl methacrylate polymer elastomer for example can be used as the adhesive.

The pressure-sensitive adhesive used in the pressure-sensitive adhesive layer in the present invention can be used without particular limitation as long as it is capable of removable adhesion without leaving adhesive deposits or without contamination on the surface of a panel such as liquid crystal panel. The pressure-sensitive adhesive includes various pressure-sensitive adhesives such as acrylic pressure-sensitive adhesives, natural rubber-based pressure-sensitive adhesives, synthetic rubber-based pressure-sensitive adhesives, ethylene-vinyl acetate copolymer-based pressure-sensitive adhesives, ethylene-acrylate-based pressure-sensitive adhesives, styrene-isoprene block copolymer-based pressure-sensitive adhesives, styrene-butadiene block copolymer-based pressure-sensitive adhesives, polyurethane-based pressure-sensitive adhesives, and polyester-based pressure-sensitive adhesives.

Among these pressure-sensitive adhesives, the acrylic pressure-sensitive adhesives are preferably used because they are highly transparent and easily exhibit excellent adhesion to optical sheets.

In the acrylic pressure-sensitive adhesive, a monomer component (meth) acrylic polymer containing 50 to 100% by weight of (meth)acrylates having a C1 to C14 alkyl group is used as a base polymer.

The (meth) acrylic polymer used in the present invention is not particularly limited as long as it is a (meth)acrylic polymer having the adhesion described above.

The (meth) acrylic polymer in the present invention refers to an acrylic polymer and/or a methacrylic polymer. The alkyl (meth)acrylate refers to an alkyl acrylate and/or an alkyl methacrylate, and the (meth) acrylate refers to an acrylate and/or methacrylate.

Examples of (meth) acrylates having a C1 to C14 alkyl group include methyl (meth)acrylate, ethyl (meth)acrylate, n-butyl (meth) acrylate, s-butyl (meth)acrylate, t-butyl (meth) acrylate, isobutyl (meth)acrylate, hexyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, n-dodecyl (meth)acrylate, n-tridecyl (meth)acrylate, and n-tetradecyl (meth)acrylate.

Among them, when used in the removable pressure-sensitive adhesive sheet used in the present invention, (meth) acrylates having a C6 to C14 alkyl group, such as hexyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, n-dodecyl (meth)acrylate, n-tridecyl (meth)acrylate, and n-tetradecyl (meth)acrylate is suitably used. By using a (meth)acrylic polymer consisting of (meth)acrylates mainly those having a C6 to C14 alkyl group, it becomes easy to control a peel adhesion to an adherend low, and excellent removability is obtained.

The (meth)acrylates having a C1 to C14 alkyl group may be used alone or as a mixture of two or more thereof, and the content thereof is preferably 50 to 100% by weight, more preferably 60 to 99.5% by weight, even more preferably 70 to 99% by weight, based on all monomers of the (meth) acrylic polymer.

In the present invention, functional group-containing monomers capable of reacting with a crosslinking agent, and other polymerizable monomer components for regulating the glass transition point and removability of the (meth) acrylic polymer can be used in addition to the (meth)acrylates having a C1 to C14 alkyl group.

As the functional group-containing monomers, it is possible to use, for example, a component having a functional group serving as a crosslinking point, such as a carboxyl group-containing monomer, an acid anhydride group-containing monomer, a hydroxyl group-containing monomer, an amino group-containing monomer, an epoxy group-containing monomer, an isocyanate group-containing monomer, or an aziridine group-containing monomer.

The carboxyl group-containing monomer includes, for example, (meth)acrylic acid, carboxyethyl (meth)acrylate, carboxypentyl (meth)acrylate, itaconic acid, maleic acid, fumaric acid, crotonic acid, and isocrotonic acid.

The acid anhydride group-containing monomer includes, for example, maleic anhydride, itaconic anhydride, and acid anhydrides of the above-described carboxyl group-containing monomers.

The hydroxyl group-containing monomer includes, for example, 2-hydroxyethyl (meth)acrylate, 2-hydropropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl acrylate, N-methylol (meth)acrylamide, vinyl alcohol, allyl alcohol, 2-hydroxyethyl vinyl ether, 4-hydroxybutyl vinyl ether, and diethylene glycol monovinyl ether.

Examples of the amino group-containing monomer include aminoethyl (meth)acrylate, N, N-dimethylaminoethyl (meth)acrylate, and N, N-dimethylaminopropyl (meth)acrylate.

Examples of the epoxy group-containing monomer include glycidyl (meth)acrylate, methylglycidyl (meth)acrylate, and allyl glycidyl ether.

Examples of the isocyanate group-containing monomer include 2-methacryloyloxyethyl isocyanate.

The functional group-containing (meth)acrylates may be used alone or as a mixture of two or more thereof. The content thereof in total is preferably 0.1 to 15% by weight, more preferably 0.2 to 12% by weight and particularly preferably 0.3 to 10% by weight in the total monomer components of the (meth)acrylic polymer. When the content of the functional group-containing (meth) acrylate is decreased to less than 0.1% by weight, crosslinkage by a crosslinking agent becomes insufficient and then the cohesive strength of a pressure-sensitive adhesive composition becomes so low as to bring a tendency to result in an adhesive residue. On the other hand, when the content of the functional group-containing (meth)acrylate is increased to more than 15% by weight, the cohesive strength of a pressure-sensitive adhesive composition becomes so high as to lower fluidity and then the wetting of the adherend becomes so insufficient as to bring a tendency to result in peeling off.

Polymerizable monomers for adjusting glass transition point and peeling properties of the (meth) acrylic polymer can be used as other polymerizable monomer components in a range of not deteriorating the effect of the present invention.

Properly usable examples of other polymerizable monomer components include components for improving cohesive strength or heat resistance, such as a sulfonic acid group-containing monomer, a phosphoric acid group-containing monomer, a cyano group-containing monomer, vinyl esters and aromatic vinyl compounds, and components having a functional group for acting as an improvement in adhesive strength or a crosslinking point, such as an amide group-containing monomer, an imide group-containing monomer, N-acryloyl morpholine and vinyl ethers.

Examples of the sulfonic acid group-containing monomer include styrenesulfonic acid, allylsulfonic acid,

2-(meth)acrylamido-2-methylpropanesulfonic acid, (meth)acrylamidopropanesulfonic acid, sulfopropyl (meth)acrylate, (meth)acryloyloxynaphthalenesulfonic acid, and sodium vinylsulfonate.

Examples of the phosphoric acid group-containing monomer include 2-hydroxyethylacryloyl phosphate.

Examples of the cyano group-containing monomer include acrylonitrile and methacrylonitrile.

Examples of the vinyl ester include vinyl acetate, vinyl propionate, and vinyl laurate.

Examples of the aromatic vinyl compound include styrene, chlorostyrene, chloromethylstyrene, $\alpha$-methylstyrene, and other substituted styrene.

Examples of the amide group-containing monomer include acrylamide, methacrylamide, diethylacrylamide, N-vinylpyrrolidone, N,N-dimethylacrylamide, N,N-dimethylmethacrylamide, N,N-diethylacrylamide, N,N-diethylmethacrylamide, N,N'-methylenebisacrylamide, N,N-dimethylaminopropylacrylamide, N,N-dimethylaminopropylmethacrylamide, and diacetone acrylamide.

Examples of the imide group-containing monomer include cyclohexylmaleimide, isopropylmaleimide, N-cyclohexylmaleimide, and itaconeimide.

Examples of the vinyl ether include methyl vinyl ether, ethyl vinyl ether, and isobutyl vinyl ether.

The above-mentioned other polymerizable monomer components may be used singly or as a mixture of two or more thereof, and the content thereof in total is preferably 0 to 35% by weight, more preferably 0 to 30% by weight and particularly preferably 0 to 25% by weight in the total monomer components of the (meth) acrylic polymer. The use of the other polymerizable monomer components allows favorable adhesive property to be properly adjusted.

The glass transition temperature (Tg) of the above-mentioned (meth)acrylic polymer as a base polymer is typically preferably -100 to 0°C, more preferably -80 to -10°C. A glass transition temperature higher than 0°C occasionally allows sufficient adhesive strength with difficulty. The glass transition temperature (Tg) of the (meth)acrylic polymer can be adjusted within the above-mentioned range by properly changing the used monomer components and composition ratio thereof. The (meth) acrylic polymer may be any of copolymers such as a random copolymer, a block copolymer and a graft copolymer.

The acrylic polymer of the present invention is obtained by a polymerization method which is generally used as a procedure for synthesizing an acrylic polymer such as solution polymerization, emulsion polymerization, bulk polymerization and suspension polymerization.

In the present invention, solution polymerization or emulsion polymerization is preferably used because the objective pressure-sensitive adhesive composition can be relatively easily obtained.

As solution polymerization, a method known in the art as a method for solution polymerization of a pressure-sensitive adhesive is used. For example, the monomers or copolymerizable monomers are first mixed, then a polymerization initiator and a solvent are added, and the monomers are subjected to solution polymerization.

As the polymerization initiator used in the present invention, azo compounds and peroxides are used.

Examples of the azo compounds include 2,2'-azobisisobutyronitrile, 2,2'-azobisisovaleronitrile, 2,2'-azobis(4-methoxy-2,4-dimethylvaleronitrile), 2,2'-azobis(2,4-dimethylvaleronitrile), 2,2'-azobis(2-methylbutyronitrile), 1,1'-azobis(cyclohexane-1-carbonitrile), 2,2'-azobis(2,4,4-trimethylpentane), and dimethyl-2,2'-azobis(2-methylpropionate).

Examples of the peroxides include benzoyl peroxide, t-butyl hydroperoxide, di-t-butyl hydroperoxide, t-butyl peroxybenzoate, dicumyl peroxide, 1,1-bis(t-butylperoxy)-3,3,5-trimethyl cyclohexane, and 1,1-bis(t-butylperoxy) cyclododecane.

As the solvent, a wide variety of general organic solvents are used. Examples of such organic solvents include esters such as ethyl acetate and n-butyl acetate, aromatic hydrocarbons such as toluene and benzene, aliphatic hydrocarbons such as n-hexane and n-heptane, alicyclic hydrocarbons such as cyclohexane and methylcyclohexane, and ketones such as methyl ethyl ketone and methyl isobutyl ketone. The solvents may be used alone or as a mixture of two or more thereof.

The polymerization initiators may be used alone or as a mixture of two or more thereof. The content of the whole thereof is usually from about 0.001 to 0.4 parts by weight, preferably from 0.002 to 0.2 parts by weight, based on 100 parts by weight of the monomers.

In emulsion polymerization, the monomers or copolymerizable monomers are mixed, then compounded with an emulsifier and water, and emulsified to prepare an emulsion. At this time, all or a part of the monomers may be blended, and the remainder may be added dropwise during polymerization. Then, a polymerization initiator and if necessary water are added to this emulsion which is then subjected to emulsion polymerization.

The emulsifier, the polymerization initiator and the like used in the present invention are not particularly limited and can be used through proper selection.

Examples of the emulsifiers used in the present invention include anionic emulsifiers such as alkyl sulfates, alkyl benzenesulfonates, alkyl sulfosuccinates, polyoxyethylene alkyl sulfates and polyoxyethylene alkyl phosphates, and nonionic emulsifiers such as polyoxyethylene alkyl ethers, polyoxyethylene alkyl phenyl ethers, polyoxyethylene-polyoxypropylene block polymers, sorbitan fatty acid esters and polyoxyethylene fatty acid esters. These emulsifiers may be used alone or as a mixture of two or more thereof.

As reactive emulsifiers, those emulsifiers to which radical polymerizable functional groups (reactive functional groups) such as a propenyl group, an allyl group, a (meth) acryloyl group and an allyl ether group have been introduced may be used. Such emulsifiers include those described in, for example, JP-A 4-53802, and examples include AQUARONHS-10, HS-20, KH-10, BC-05, BC-10 and BC-20 (manufactured by Dai-Ichi Kogyo Seiyaku Co., Ltd.), ADEKA REASOAP SE-10N (manufactured by ADEKA CORPORATION), and LATEMUL PD-104 (manufactured by Kao Corporation).

From the viewpoint of polymerization stability or mechanical stability, the amount of the emulsifier used is preferably 0.1 to 10 parts by weight, more preferably 0.3 to 5 parts by weight, based on 100 parts by weigh of the monomers.

Water may be blended only during the preparation of the emulsion, or thereafter further blended, which can properly be selected in accordance with the after-mentioned polymerization method. The blending amount of water is not particularly limited but prepared so that the solid content concentration of the (meth) acrylic polymer after the emulsion polymerization becomes 30 to 75% by weight, preferably 35 to 70% by weight.

Examples of the polymerization initiator for emulsion polymerization used in the present invention include, but are not limited to, azo initiators such as 2,2'-azobisisobutyronitrile, 2,2'-azobis(2-amidinopropane)dihydrochloride, 2,2'-azobis[2-(5-methyl-2-imidazolin-2-yl)propane]dihydroch loride, 2,2'-azobis(2-methylpropionamidine)disulfate, 2,2'-azobis(N,N'-dimethyleneisobutylamidine) and 2,2'-azobis[N-(2-carboxyethyl)-2-methylpropionamidine]hydra te, persulfates such as potassium persulfate and ammonium persulfate, peroxide initiators such as di(2-ethylhexyl)peroxydicarbonate, di(4-tert-butylcyclohexyl)peroxydicarbonate, di-sec-butyl peroxydicarbonate, tert-butyl peroxyneodecanoate, tert-hexyl peroxypivalate, tert-butyl peroxypivalate, dilauroyl peroxide, di-n-octanoyl peroxide, 1,1,3,3-tetramethyl butyl peroxy-2-ethyl hexanoate, di(4-methylbenzoyl)peroxide, benzoyl peroxide, tert-butyl peroxyisobutyrate, 1,1-di(tert-hexyl peroxy)cyclohexane, tert-butyl hydroperoxide and hydrogen peroxide, and redox initiators with peroxides and reducing agents combined, such as a combination of persulfate and sodium hydrogen sulfite, and a combination of peroxide and sodium ascorbate.

The above-mentioned polymerization initiators may be used singly or as a mixture of two or more thereof, and the content thereof in total is typically preferably 0.001 to 0.1 parts by weight, more preferably 0. 002 to 0. 05 parts by weight with respect to 100 parts by weight of the monomers.

A method of emulsion polymerization is not particularly limited, and can properly be selected from a batch polymerization method (a batch charge method), a continuous dropping method (a monomer dropping method and a monomer emulsion dropping method), and a polymerization method with a combination thereof.

In a batch polymerization method, for example, a monomer mixture, an emulsifier and water are charged into a reaction vessel and emulsified by stirring and mixing to prepare an emulsion, and thereafter a polymerization initiator and, as required, water are further added to this reaction vessel to perform emulsion polymerization.

In a continuous dropping method, for example, a monomer mixture, an emulsifier and water are first added and emulsified by stirring and mixing to prepare a dropping liquid, and simultaneously a polymerization initiator and water are charged into a reaction vessel to subsequently drop the dropping liquid into the reaction vessel and perform emulsion polymerization.

Known additives such as pH buffer agent, a neutralizer, a foam inhibitor and a stabilizer canproperlybe used as additives after the emulsion polymerization.

In the present invention, a chain transfer agent may be used for the polymerization. The use of these chain transfer agents allows the molecular weight of the (meth) acrylic polymer to be adjusted.

Examples of the chain transfer agent include lauryl mercaptan, glycidyl mercaptan, mercaptoacetic acid, 2-mercaptoethanol, thioglycolic acid, 2-ethylhexyl thioglycolate and 2,3-dimercapto-1-propanol.

These chain transfer agents may be used singly or as a mixture of two or more thereof, and the content thereof in total is preferably 0.01 to 1 part by weight based on 100 parts by weight of the monomers.

When a (meth) acrylic polymer is particularly used in the pressure-sensitive adhesive composition of the present invention, pressure-sensitive adhesive sheets further excellent in heat resistance and in low contamination are obtained by appropriately crosslinking the (meth)acrylic polymer.

Examples of a specific means for a crosslinking method include a so-called method of using crosslinking agents, wherein those compounds (for example, an isocyanate compound, an epoxy compound, a melamine-based compound, an aziridine compound, a carbodiimide compound and a metallic chelate compound) having groups capable of reacting with a carboxyl group, a hydroxyl group, an amino group and an amido group appropriately contained as crosslinking point in a (meth) acrylic polymer is added to, and reacted with, the (meth)acrylic polymer. These compounds may be used alone, or may be used by mixing two or more kinds of them. In particular, from the viewpoint of obtaining suitable cohesion force, isocyanate compounds and epoxy compounds are particularly preferably used.

Examples of the isocyanate compounds include aromatic isocyanates such as tolylene diisocyanate and xylene diisocyanate, alicyclic isocyanates such as isophorone diisocyanate, aliphatic isocyanates such as hexamethylene diisocyanate.

Specific examples of the isocyanate compounds include lower aliphatic polyisocyanates such as butylene diisocyanate and hexamethylene diisocyanate, alicyclic isocyanates such as cyclopentylene diisocyanate, cyclohexylene

diisocyanate and isophorone diisocyanate, aromatic isocyanates such as 2,4-tolylene diisocyanate, 4,4'-diphenylmethane diisocyanate and xylylene diisocyanate, a trimethylolpropane/tolylenediisocyanate trimer adduct (trade name: Coronate L, manufactured by Nippon Polyurethane Industry Co., Ltd.), a trimethylolpropane/hexamethylene diisocyanate trimer adduct (trade name: Coronate HL, manufactured by Nippon Polyurethane Industry Co., Ltd.), and isocyanate adducts such as an isocyanurate derivative of hexamethylene diisocyanate (trade name: Coronate HX, manufactured by Nippon Polyurethane Industry Co., Ltd.). One or more of these compounds may be used singly or in combination.

Examples of the epoxy compounds include N,N,N',N'-tetraglycidyl-m-xylenediamine (trade name: Tetrad-X, manufactured by Mitsubishi Gas Chemical Company, Inc.) and 1,3-bis(N,N-diglycidylaminomethyl)cyclohexane (trade name: Tetrad-C, manufactured by Mitsubishi Gas Chemical Company, Inc.) . One or more of these compounds maybe used singly or in combination.

The melamine-based compound includes a hexamethylolmelamine. Examples of the aziridine derivative include products commercially available under trade names HDU, TAZM and TAZO (all manufactured by Sogo Pharmaceutical Co., Ltd.). These compounds may be used alone or as a mixture of two or more thereof.

A water-soluble crosslinking agent is preferably used in crosslinking the (meth)acrylic polymer obtained by emulsion polymerizationu.

Examples of the water-soluble crosslinking agent include epoxy compounds such as polyethylene glycol glycidyl ether, water-dispersible isocyanate compounds, oxazoline compounds, aziridine compounds, hydrophilized carbodiimide compounds, active methylol compounds, active alkoxymethyl compounds, and metal chelate compounds.

The amount of the crosslinking agent used depends on balance between the crosslinking agent and the (meth)acrylic polymer to be crosslinked, and is appropriately selected depending on use thereof as a pressure-sensitive adhesive sheet. In order to obtain sufficient heat resistance by the cohesive strength of the acrylic pressure-sensitive adhesive, generally the crosslinking agent is contained preferably in an amount of 0.01 to 15 parts by weight, more preferably 0.5 to 10 parts by weight, relative to 100 parts by weight of the (meth)acrylic polymer. When the content is less than 0.01 parts by weight, crosslinking formation by the crosslinking agent becomes insufficient, the cohesive strength of the pressure-sensitive adhesive composition is reduced, and sufficient heat resistance is not obtained in some cases, and there is a tendency that it becomes cause for an adhesive residue. On the other hand, when the content exceeds 15 parts by weight, the cohesive strength of the polymer is great, flowability is reduced, and wetting on an adherend becomes insufficient, and there is a tendency that this becomes cause for peeling.

Alternatively, a multifunctional monomer containing two or more radiation-reactive unsaturated bonds is added as a substantial crosslinking agent and may be crosslinked with radiation.

As the multifunctional monomer having two or more radiation-reactive unsaturated bonds, a multifunctional monomer component having two or more of one kind or two or more kinds of radiation-reactive groups capable of crosslinking (curing) by irradiation of radiation, such as a vinyl group, an acryloyl group, a methacryloyl group, and a vinylbenzyl group, is used. Generally, a component having 10 or less radiation-reactive unsaturated bonds is suitably used. Two or more kinds of multifunctional monomers may be used jointly. Examples of the multifunctional monomer include ethyleneglycol di(meth)acrylate, diethylene glycol di(meth)acrylate, tetraethyleneglycol di(meth)acrylate, neopentylglycol di(meth)acrylate, 1,6hexanediol di(meth)acrylate, trimethylolpropane tri(meth)acrylate, pentaerythritol tri(meth)acrylate, dipentaerythritol hexa(meth)acrylate, divinylbenzene, and N,N'-methylenebisacrylamide.

The amount of the multifunctional monomer used depends on balance between the multifunctional monomer and the (meth) acrylic polymer to be crosslinked, and is appropriately selected depending on use thereof as a pressure-sensitive adhesive sheet. In order to obtain sufficient heat resistance by the cohesive strength of the acrylic pressure-sensitive adhesive, generally the monomer is preferably blended in an amount of 0.1 to 30 parts by weight relative to 100 parts by weight of the (meth)acrylic polymer. From the viewpoint of flexibility and tackiness, the monomer is preferably blended in an amount of 10 parts by weight or less relative to 100 parts by weight of the (meth)acrylic polymer.

Examples of the radiation include ultraviolet ray, laser ray, $\alpha$-ray, $\beta$-raw, $\gamma$-ray, X-ray, and electron beam. From the viewpoint of controllability, good handleability and costs, ultraviolet ray is suitably used. More preferably, ultraviolet ray having a wavelength of 200 to 400 nm is used. Ultraviolet ray can be applied using an appropriate light source such as a high pressure mercury lamp, a micro-wave excitation-type lamp, and a chemical lamp.

When ultraviolet ray is used as irradiation, a photopolymerization initiator is added to the acrylic pressure-sensitive adhesive.

The photopolymerization initiator depends on the kind of a radiation-reactive component, and may be a substance which produces a radical or a cation when irradiated with an ultraviolet ray having an appropriately wavelength which can trigger the polymerization reaction. Examples of the photoradical polymerization initiator include benzoins such as benzoin, benzoin methyl ether, benzoin ethyl ether, methyl o-benzoylbenzoate-p-benzoin ethyl ether, benzoin isopropyl ether, and $\alpha$-methylbenzoin, acetophenes such as benzylmethylketal, trichloroacetophenone, 2,2-diethoxyacetophenone, and 1-hydroxycyclohexyl phenyl ketone, propiophenones such as 2-hydroxy-2-methylpropiophenone and 2-hydroxy-4'-isopropyl-2-methylpropiophenone, benzophenones such as benzophenone, methylbenzophenone, p-chlorobenzophenone, and p-dimethylaminobenzophenone, thioxanthons such as 2-chlorothioxanthon, 2-ethylthioxanthon,

and 2-isopropylthioxanthon, acylphosphine oxides such as bis(2,4,6-trimethylbenzoyl)-phenylphosphine oxide, 2,4,6-trimethylbenzoyldiphenylphosphine oxide, and (2,4,6-trimethylbenzoyl)-(ethoxy)-phenylphosphine oxide, benzil, dibenzsuberone, and α-acyloxime ester.

Examples of a photocation polymerization initiator include onium salts such as an aromatic diazonium salt, an aromatic iodonium salt, and an aromatic sulfonium salt, organometallic complexes such as an ion-allene complex, a titanocene complex, and an aryl silanol-aluminum complex, nitrobenzyl ester, sulfonic acid derivative, phosphoric acid ester, phenolsulfonic acid ester, diazonaphthoquinone, and N-hydroxyimidosulfonate.

Two or more kinds of the photopolymerization initiators may be used jointly. It is preferable that the photopolymerization initiator is blended usually in the range of 0.1 to 10 parts by weight, preferably 0.2 to 7 parts by weight, relative to 100 parts by weight of the acrylic polymer.

Further, it is also possible to use a photoinitiation polymerization assistant such as amines jointly. Examples of the photoinitiation assistant include 2-dimethylaminoethyl benzoate, dimethylaminoacetophenone, ethyl p-dimethylaminobenzoate, and isoamyl p-dimethylaminobenzoate. Two or more kinds of the photopolymerization initiation assistants may be used jointly. It is preferable that the polymerization initiation assistant be blended at 0.05 to 10 parts by weight, particularly 0.1 to 7 parts by weight, relative to 100 parts by weight the acrylic polymer.

Further, the previously known tackifiers, or the previously known various additives such as a surface wetting agent, a surfactant, a leveling agent, an antioxidant, a corrosion preventing agent, a photo stabilizer, an ultraviolet absorber, a polymerization inhibitor, a silane coupling agent, inorganic or organic fillers, metal powders, and pigments, in the form of powder, granule and foil may be appropriately added to the pressure-sensitive adhesive composition used in the pressure-sensitive adhesive **sheet used in the present invention,** depending on utility.

Generally, the pressure-sensitive adhesive layer in the present invention is such that the pressure-sensitive adhesive composition is crosslinked. In addition, the pressure-sensitive adhesive **sheet used in the present invention is** such that the pressure-sensitive adhesive layer is formed on 66 a base material layer (supporting film). Thereupon, crosslinking of the pressure-sensitive adhesive composition is generally performed after coating of the pressure-sensitive adhesive composition, or alternatively the pressure-sensitive adhesive layer consisting of the pressure-sensitive adhesive composition after crosslinking may be transferred onto a supporting film.

A method of forming the pressure-sensitive adhesive layer on a film is not particularly limited. For example, the layer is prepared by coating the pressure-sensitive adhesive composition on a supporting film and then drying the composition to remove a polymerization solvent (an organic solvent, water or a water solution) to form a pressure-sensitive adhesive layer on the supporting film. Thereafter, aging may be performed for the purpose of adjusting transference of components of the pressure-sensitive adhesive layer or adjusting a crosslinking reaction. Alternatively, when the pressure-sensitive adhesive sheet is prepared by coating the pressure-sensitive adhesive composition on a supporting film, a polymerization solvent and/or one or more kinds of solvents other than a polymerization solvent may be newly added to the composition so that the composition can be uniformly coated on a supporting film.

As a method of forming the pressure-sensitive adhesive layer of the present invention, the known method used for preparing pressure-sensitive adhesive sheets is used. Specific examples include roll coating, gravure coating, reverse coating, roll brushing, spray coating, and air knife coating methods, immersing and curtain coating method, and extruding coating method with a die coater.

The pressure-sensitive adhesive **sheet used in the present** invention is such that the pressure-sensitive adhesive layer is coated to a thickness of usually 3 to 100 μm, preferably around 5 to 50 μm, on one side of a supporting film, to form a sheet in the form of a sheet or a tape.

The pressure-sensitive adhesive **sheet used in the present** invention is used particularly preferably in plastic products in which static electricity is easily generated. The pressure-sensitive adhesive sheet is particularly useful as a surface-protective film used for the purpose of protecting the surfaces of optical members used in a liquid crystal display, such as a polarizing plate, a wavelength plate, a retardation plate, an optical compensating film, a reflecting sheet, and a brightness enhancement film.

## EXAMPLES

Examples which specifically show the construction and effect of the present invention will be explained below. Evaluation items in Examples were measured as follows:

<Measurement of molecular weight>

A molecular weight was measured using a GPC apparatus (HLC-8220GPC manufactured by Tosoh Corporation). Measuring conditions are as follows.

- Sample concentration: 0.2 wt% (THF solution)

- Sample injection volume: 10 μl
- Eluent: THF
- Flow rate: 0.6 ml/min.
- Measuring temperature: 40°C
- Columns:

  Sample column; TSK guard column Super HZ-H (1 column) + TSK gel Super HZM-H (2 columns)
  Reference column; TSK gel Super H-RC (1 column)

- Detector: Refractive index detector (RI)

Amolecular weight was obtained as polystyrene-equivalent molecular weight.

<Measurement of glass transition temperature (Tg)>

The glass transition temperature Tg (°C) of the obtained (meth)acrylic polymer was obtained by the following equation using the following reference values as glass transition temperature $Tg_n$ (°C) of a homopolymer of each monomer.

$$1/(Tg + 273) = \Sigma[W_n/(Tg_n + 273)]$$

wherein Tg (°C) represents a glass transition temperature (°C) of a copolymer, $W_n$ (-) represents a weight fraction of eachmonomer, $Tg_n$ (°C) represents a glass transition temperature (°C) of a homopolymer of each monomer, and n represents a kind of each monomer.
Reference values:

- 2-Ethylhexyl acrylate: -70°C
- n-Butyl methacrylate: 20°C
- 2-Hydroxyethyl acrylate: -15°C
- Acrylic acid: 106°C

Cited reference values were from the description in "Synthesis-Design and New Utility Development of Acryl Resin" (published by publishing section of Chubu Keiei Kaihatsu Center).

<Measurement of melting point (Tm)>

The melting point (°C) of each resin (polymer) used in the antistatic film was measured with a differential scanning calorimeter (DSC) manufactured by Seiko Instruments Inc. The measurement conditions were that about 5 mg sample was taken, kept at 200°C for 5 minutes, then cooled to 40°C at a decreasing temperature of 10°C/min., and then melted at an increasing temperature of 10°C/min. The peak temperature of a melting curve obtained at this time was determined as a melting point (°C).

<Preparation of films>

(Antistatic film (A))

75 parts by weight of a random polypropylene (WINTEC WFW4, melting point 135°C, manufactured by Japan Polypropylene Corporation) polymerized with a metallocene catalyst, and 25 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition, and a random polypropylene (WINTEC WFW4, melting point 135°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (A).

(Antistatic film (B))

75 parts by weight of a random polypropylene (WINTEC WFX4, melting point 125°C, manufactured by Japan Polypropylene Corporation) polymerized by a metallocene catalyst, and 25 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a filmof a 10-μm antistatic layer and a 50-μm base material layer. The side of the resulting film opposite to the surface of the antistatic layer was subjected to corona discharge treatment, to give an antistatic film (B).

(Antistatic film (C))

75 parts by weight of a random polypropylene (F327, melting point 138°C, manufactured by Prime Polymer Co., Ltd.) polymerized with a catalyst other than metallocene, and 25 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition and the random polypropylene (F327, melting point 138°C, manufactured by Prime Polymer Co., Ltd.) were subjected to two-layer coextrusion as an antistatic layer and a base material layer, respectively, through a T-die (dice temperature: 220°C), and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (C).

(Antistatic film (D))

75 parts by weight of a random polypropylene (F327, melting point 138°C, manufactured by Prime Polymer Co., Ltd.) polymerized with a catalyst other than metallocene, and 25 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (D).

(Antistatic film (E))

75 parts by weight of a random polypropylene (J-5710, melting point 152°C, manufactured by Prime Polymer Co., Ltd.) polymerized with a catalyst other than metallocene, and 25 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (E).

(Antistatic film (F))

75 parts by weight of a homo polypropylene (ZS1327A, melting point 162°C, manufactured by Prime Polymer Co., Ltd.) polymerized with a catalyst other than metallocene, and 25 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition and the homo polypropylene (ZS1327A, melting point 162°C, manufactured by Prime Polymer Co., Ltd.) were subjected to two-layer coextrusion as an antistatic layer and a base material layer, respectively, through a T-die (dice temperature: 220°C) and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give

an antistatic film (F).

(Non-antistatic film (G))

A random polypropylene (WINTEC WFX4, melting point 125°C, manufactured by Japan Polypropylene Corporation) polymerized with a metallocene catalyst was subj ected to monolayer extrusion as a base material layer through a T-die (dice temperature: 220°C) and passed between cast rolls at 20°C at a take-off speed of 5 m/min. to give a film of a 60-μm base material layer. One side of the resulting film was subjected to corona discharge treatment, to give a non-antistatic film (G).

(Non-antistatic film (H))

A random polypropylene (WINTEC WFW4, melting point 135°C, manufactured by Japan Polypropylene Corporation) polymerized with a metallocene catalyst was subj ected to monolayer extrusion as a base material layer through a T-die (dice temperature: 220°C) and passed between cast rolls at 20°C at a take-off speed of 5 m/min. to give a film of a 60-μm base material layer. One side of the resulting film was subjected to corona discharge treatment, to give a non-antistatic film (H).

(Non-antistatic film (I))

A random polypropylene (F327, melting point 138°C, manufactured by Prime Polymer Co., Ltd.) polymerized with a catalyst other than metallocene was subjected to monolayer extrusion as a base material layer through a T-die (dice temperature: 220°C) and passed between cast rolls at 20°C at a take-off speed of 5 m/min. to give a film of a 60-μm base material layer. One side of the resulting film was subjected to corona discharge treatment, to give a non-antistatic film (I).

(Non-antistatic film (J))

A homo polypropylene (ZS1327A, melting point 162°C, manufactured by Prime Polymer Co., Ltd.) polymerized with a catalyst other than metallocene was subjected to monolayer extrusion as a base material layer through a T-die (dice temperature: 220°C) and passed between cast rolls at 20°C at a take-off speed of 5 m/min. to give a film of a 60-μm base material layer. One side of the resulting film was subjected to corona discharge treatment, to give a non-antistatic film (J).

(Antistatic film (K))

75 parts by weight of a polyethylene (L705 manufactured by Sumitomo Chemical Co., Ltd.) and 25 parts by weight of a polymeric antistatic agent (Pelestat VH230 manufactured by Sanyo Chemical Industries, Ltd.) were melt-kneaded with a twin screw extruder (set temperature of a cylinder: 200°C) to form pellets. This resin composition and a polyethylene (LF440C manufactured by Japan Polyethylene Corporation) were subjected to two-layer coextrusion as an antistatic layer and a base material layer, respectively, through a T-die (dice temperature: 200°C) and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (K).

(Antistatic film (L))

75 parts by weight of a block polypropylene (NEWSTREN SB8000 manufactured by Japan Polypropylene Corporation) polymerized with a catalyst other than metallocene, and 25 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition and the block polypropylene (NEWSTREN SB8000 manufactured by Japan Polypropylene Corporation) were subjected to two-layer coextrusion as an antistatic layer and a base material layer, respectively, through a T-die (dice temperature: 200°C) and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (L).

(Antistatic film (M))

75 parts by weight of a polyethylene (Petrothene 0M05A manufactured by Tosoh Corporation) and 25 parts by weight of a polymeric antistatic agent (Pelestat VH230 manufactured by Sanyo Chemical Industries, Ltd.) were melt-kneaded with a twin screw extruder (set temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 200°C), and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (M).

(Antistatic film (N))

A polyester film (T100G, thickness 38 μm, manufactured by Mitsubishi Chemical Polyester Film Co., Ltd.) subjected to antistatic treatment was used as an antistatic film (N).

(Antistatic film (0))

80 parts by weight of a random polypropylene (WINTEC WFX4, melting point 125°C, manufactured by Japan Polypropylene Corporation) polymerized with a metallocene catalyst, and 20 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a filmof a 10-μm antistatic layer anda 50-μm base material layer. The side of the resulting film opposite to the surface of the antistatic layer was subjected to corona discharge treatment, to give an antistatic film (O).

(Antistatic film (P))

90 parts by weight of a random polypropylene (WINTEC WFX4, melting point 125°C, manufactured by Japan Polypropylene Corporation) polymerized with a metallocene catalyst, and 10 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (P).

(Antistatic film (Q))

60 parts by weight of a random polypropylene (WINTEC WFX4, melting point 125°C, manufactured by Japan Polypropylene Corporation) polymerized with a metallocene catalyst, and 40 parts by weight of a polymeric antistatic agent (Pelestat VH230 manufactured by Sanyo Chemical Industries, Ltd.), were melt-kneaded with a twin screw extruder (set temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (Q).

(Antistatic film (R))

90 parts by weight of a random polypropylene (WINTEC WFX4, melting point 125°C, manufactured by Japan Polypropylene Corporation) polymerized with a metallocene catalyst, and 10 parts by weight of an antistatic agent (Resistat PE132, polyhydric alcohol derivative, manufactured by Dai-ichi Kogyo Seiyaku Co., Ltd.) that was not a polymeric antistatic agent of an olefin block and a hydrophilic block, were melt-kneaded with a twin screw extruder (set

temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a film of a 10-μm antistatic layer and a 50-μm base material layer. The side of the resulting film opposite to the surface of the antistatic layer was subjected to corona discharge treatment, to give an antistatic film (R).

(Antistatic film (S))

90 parts by weight of a random polypropylene (WINTEC WFX4, melting point 125°C, manufactured by Japan Polypropylene Corporation) polymerized with a metallocene catalyst, and 10 parts by weight of an antistatic agent (Entira MK400, ionomer, manufactured by DuPont-Mitsui Polychemicals Co., Ltd.) that was not a polymeric antistatic agent of an olefin block and a hydrophilic block, were melt-kneaded with a twin screw extruder (set temperature of a cylinder: 220°C) to form pellets. This resin composition, and a random polypropylene (WINTEC WFX4, melting point 125°C, manufactured by Japan Polypropylene Corporation) polymerized with a metallocene catalyst, were subjected to two-layer coextrusion as an antistatic layer and a base material layer, respectively, through a T-die (dice temperature: 220°C), and passed between cast rolls at 20°C at a take-off speed of 5 m/min. to give a film of a 10-μm antistatic layer and a 50-μm base material layer. The side of the resulting film opposite to the surface of the antistatic layer was subj ected to corona discharge treatment, to give an antistatic film (S).

<Preparation of (meth)acrylic polymer>

(Acrylic polymer (A))

A four-neck flask equipped with a stirrer, a thermometer, a nitrogen gas introducing tube and a condenser was charged with 200 parts by weight of 2-ethylhexyl acrylate, 8 parts by weight of 2-hydroxyethyl acrylate, 0.4 part by weight of 2,2' -azobisisobutyronitrile as a polymerization initiator, and 312 parts by weight of ethyl acetate, then a nitrogen gas was introduced under gentle stirring, and a polymerization reaction was performed for about 6 hours while maintaining a liquid temperature in a flask at around 65°C, to prepare a solution (40% by weight) of an acrylic polymer (A) . This acrylic polymer (A) had a weight-average molecular weight of 500, 000 and a glass transition temperature (Tg) of -68°C.

(Acrylic polymer (B))

A monomer mixture consisting of 50 parts by weight of 2-ethylhexyl acrylate, 50 parts by weight of n-butylmethacrylate and 2 parts by weight of acrylic acid, 1.5 parts by weight of polyoxyethylene nonyl phenyl ether as an emulsifier, 1.5 parts by weight of polyoxyethylene nonyl phenyl ether ammonium sulfate, and 80 parts by weight of water are emulsified and dispersed. This emulsion was charged into a four-neck flask equipped with a stirrer, a thermometer, a nitrogen gas introducing tube and a condenser, and the mixture was subjected to emulsion polymerization at 50°C for 7 hours in the presence of 0.02 parts by weight of 2,2'-azobis(2-amidinopropionamidine) dihydrochoride as a polymerization initiator. Thereafter, the reaction mixture was adjusted to a solid content of 40% by weight and pH 8.0 with ammonia water and water to give an acrylic polymer (B) aqueous dispersion. The particle size of the resulting aqueous dispersion was 0.2 μm. The solvent insoluble matter in the acrylic polymer (B) was 92%, the molecular weight of the solvent soluble matter was 600,000, and the glass transition temperature (Tg) of the polymer was -31°C.

Example 1

(Preparation of a pressure-sensitive adhesive solution)

The solution (40% by weight) of the acrylic polymer (A) was diluted to 20% by weight with ethyl acetate. To 100 parts by weight of the resulting solution were added 0.8 part by weight of an isocyanurate derivative of hexamethylene diisocyanate (Coronate HX manufactured by Nippon Polyurethane Industry Co., Ltd.) and 0.4 part by weight of dibutyltin dilaurate (1 weight% ethyl acetate solution) as a crosslinking catalyst, and the mixture was mixed under stirring for about 1 minute at ordinary temperature (25°C), to prepare an acrylic pressure-sensitive adhesive solution (1).

(Preparation of a pressure-sensitive adhesive sheet)

The acrylic pressure-sensitive adhesive solution (1) was applied onto a silicone-treated side of a polyethylene terephthalate film (thickness 25 μm) subjected on one side to silicone treatment and was heated at 110°C for 3 minutes

to form a pressure-sensitive adhesive layer having a thickness of 20 μm. Then, the pressure-sensitive adhesive layer was stuck on the corona-treated surface of the antistatic film (A) prepared as described above, to prepare a pressure-sensitive adhesive sheet.

Example 2

(Preparation of a pressure-sensitive adhesive sheet)

A pressure-sensitive adhesive sheet was prepared in the same manner as in Example 1 except that the antistatic film (B) was used in place of the antistatic film (A).

Example 3

(Preparation of a pressure-sensitive adhesive sheet)

A pressure-sensitive adhesive sheet was prepared in the same manner as in Example 1 except that the antistatic film (C) was used in place of the antistatic film (A).

Example 4

(Preparation of a pressure-sensitive adhesive sheet)

A pressure-sensitive adhesive sheet was prepared in the same manner as in Example 1 except that the antistatic film (D) was used in place of the antistatic film (A).

Example 5

(Preparation of a pressure-sensitive adhesive sheet)

A pressure-sensitive adhesive sheet was prepared in the same manner as in Example 1 except that the antistatic film (E) was used in place of the antistatic film (A).

Example 6

(Preparation of a pressure-sensitive adhesive sheet)

A pressure-sensitive adhesive sheet was prepared in the same manner as in Example 1 except that the antistatic film (F) was used in place of the antistatic film (A).

Example 7

(Preparation of a pressure-sensitive adhesive solution)

To 100 parts by weight of the solid content in the acrylic polymer (B) aqueous dispersion (40% by weight) were added 4 parts by weight of an oxazoline group-containing water-soluble crosslinking agent (EPOCROSS WS500, manufactured by Nippon Shokubai Co., Ltd., oxazoline value: 220). These components were mixed under stirring at ordinary temperature (25°C) for about 1 minute, to prepare an acrylic pressure-sensitive adhesive aqueous dispersion (2).

(Formation of a pressure-sensitive adhesive sheet)

The acrylic pressure-sensitive adhesive aqueous dispersion (2) was applied onto the corona-treated surface of the antistatic film (A) prepared as described above, and then heated at 90°C for 3 minutes to form an pressure-sensitive adhesive layer having a thickness of 5 μm. Then, an untreated polyethylene film (thickness 60 μm) was stuck on the surface of the pressure-sensitive adhesive layer, to form a pressure-sensitive adhesive sheet.

Example 8

(Preparation of a pressure-sensitive adhesive sheet)

A pressure-sensitive adhesive sheet was prepared in the same manner as in Example 7 except that the antistatic film (B) was used in place of the antistatic film (A).

Example 9

(Preparation of a pressure-sensitive adhesive sheet)

A pressure-sensitive adhesive sheet was prepared in the same manner as in Example 7 except that the antistatic film (C) was used in place of the antistatic film (A).

Example 10

(Preparation of a pressure-sensitive adhesive sheet)

A pressure-sensitive adhesive sheet was prepared in the same manner as in Example 7 except that the antistatic film (D) was used in place of the antistatic film (A).

Example 11

(Preparation of a pressure-sensitive adhesive sheet)

A pressure-sensitive adhesive sheet was prepared in the same manner as in Example 7 except that the antistatic film (E) was used in place of the antistatic film (A).

Example 12

(Preparation of a pressure-sensitive adhesive sheet)

A pressure-sensitive adhesive sheet was prepared in the same manner as in Example 7 except that the antistatic film (F) was used in place of the antistatic film (A).

Example 13

(Preparation of a pressure-sensitive adhesive sheet)

A pressure-sensitive adhesive sheet was prepared in the same manner as in Example 1 except that the antistatic film (O) was used in place of the antistatic film (A).

Example 14

(Preparation of a pressure-sensitive adhesive sheet)

A pressure-sensitive adhesive sheet was prepared in the same manner as in Example 1 except that the antistatic film (P) was used in place of the antistatic film (A).

Example 15

(Preparation of a pressure-sensitive adhesive sheet)

A pressure-sensitive adhesive sheet was prepared in the same manner as in Example 1 except that the antistatic film (K) was used in place of the antistatic film (A).

Example 16

(Preparation of a pressure-sensitive adhesive sheet)

A pressure-sensitive adhesive sheet was prepared in the same manner as in Example 1 except that the antistatic film (L) was used in place of the antistatic film (A).

Example 17

(Preparation of a pressure-sensitive adhesive sheet)

A pressure-sensitive adhesive sheet was prepared in the same manner as in Example 1 except that the antistatic film (M) was used in place of the antistatic film (A).

Example 18

(Preparation of a pressure-sensitive adhesive sheet)

A pressure-sensitive adhesive sheet was prepared in the same manner as in Example 1 except that the antistatic film (Q) was used in place of the antistatic film (A).

Comparative Example 1

(Preparation of a pressure-sensitive adhesive sheet)

The acrylic pressure-sensitive adhesive solution (1) was applied onto a silicone-treated side of a polyethylene terephthalate film (thickness 25 μm) subjected on one side to silicone treatment and was heated at 110°C for 3 minutes to form a pressure-sensitive adhesive layer having a thickness of 20 μm. The pressure-sensitive adhesive layer was stuck on the corona-treated surface of the non-antistatic film (G) prepared as described above, to prepare a pressure-sensitive adhesive sheet.

Comparative Example 2

(Preparation of a pressure-sensitive adhesive sheet)

A pressure-sensitive adhesive sheet was prepared in the same manner as in Comparative Example 1 except that the non-antistatic film (H) was used in place of the non-antistatic film (G).

Comparative Example 3

(Preparation of a pressure-sensitive adhesive sheet)

A pressure-sensitive adhesive sheet was prepared in the same manner as in Comparative Example 1 except that the non-antistatic film (I) was used in place of the non-antistatic film (G).

Comparative Example 4

(Preparation of a pressure-sensitive adhesive sheet)

A pressure-sensitive adhesive sheet was prepared in the same manner as in Comparative Example 1 except that the non-antistatic film (J) was used in place of the non-antistatic film (G).

Comparative Example 5

(Preparation of a pressure-sensitive adhesive sheet)

The acrylic pressure-sensitive adhesive solution (1) was applied onto a silicone-treated side of a polyethylene terephthalate film (thickness 25 μm) subjected on one side to silicone treatment and was heated at 110°C for 3 minutes

to form a pressure-sensitive adhesive layer having a thickness of 20 μm. Then, the pressure-sensitive adhesive layer was stuck on that side of the antistatic film (N) prepared above which was opposite to the side subjected to antistatic treatment, to prepare a pressure-sensitive adhesive sheet.

Comparative Example 6

(Preparation of a pressure-sensitive adhesive sheet)

A pressure-sensitive adhesive sheet was prepared in the same manner as in Comparative Example 1 except that the antistatic film (R) was used in place of the non-antistatic film (G).

Comparative Example 7

(Preparation of a pressure-sensitive adhesive sheet)

A pressure-sensitive adhesive sheet was prepared in the same manner as in Comparative Example 1 except that the antistatic film (S) was used in place of the non-antistatic film (G).

The pressure-sensitive adhesive sheets obtained in the Examples and Comparative Examples were measured and evaluated for their total-light transmittance, haze, surface resistivity, peel adhesion, and antifouling property in the following manner.

<Measurement of total-light transmittance>

Using a haze meter (HM-150 manufactured by Murakami Color Research Laboratory Co., Ltd.), total-light transmittance was measured according to a method prescribed by JIS K7361 "Method of Testing Total-Light Transmittance of Plastic - Transparent Material".

<Measurement of haze>

Using a haze meter (HM-150 manufactured by Murakami Color Research Laboratory Co., Ltd.), haze was measured according to a method prescribed by JIS K7136 "How to Determine Haze of Plastic - Transparent Material".

<Measurement of initial surface resistivity>

Using a measuring instrument (DSM-8103 manufactured by DKK-TOA Corporation), the resistance value (Ω/□) of the surface of the antistatic layer was measured according to a method prescribed by JIS K6911 "General Method of Testing Thermosetting Plastics". The applied voltage was 500V, and at 30 seconds after the voltage was applied, initial surface resistivity was measured. This measurement was carried out in an environment at a temperature of 23°C under 50% relative humidity (RH).

<Measurement of surface resistivity after washing with water>

The pressure-sensitive adhesive sheet was immersed in heated water at 40°C for 30 minutes, then water on the sheet was wiped off with a waste cloth, and left in an environment at a temperature of 23°C under 50% relative humidity (RH) for 2 hours, to prepare an evaluation sample. Using a measuring instrument (DSM-8103 manufactured by DKK-TOA Corporation), the resistance value (Ω/□) of the surface of the antistatic layer of the sample was measured according to a method prescribed by JIS K6911 "General Method of Testing Thermosetting Plastics". The applied voltage was 500V, and at 30 seconds after the voltage was applied, the surface resistivity was measured. This measurement was carried out in an environment at a temperature of 23°C under 50% relative humidity (RH).

<Measurement of initial peel adhesion>

The pressure-sensitive adhesive sheet was cut in a width of 25 mm and then adhered at a linear pressure of 78.5 N/cm onto an acrylic resin plate (ACRYLITE L, manufactured by Mitsubishi Rayon Co., Ltd.), and 30 minutes thereafter, its adhesion was measured with a tensile testing machine under the conditions of a tensile speed of 300 mm/min. and a peel angle of 180°.

<Evaluation of antifouling function>

A pressure-sensitive adhesive surface of a pressure-sensitive adhesive tape No. 31B (manufactured by Nitto Denko Corporation) was faced with the antistatic layer of the pressure-sensitive adhesive sheet, and an acrylic pressure-sensitive adhesive of No. 31B was adhered to the antistatic layer and then lightly wiped with a waste cloth, and whether the pressure-sensitive adhesive could be easily removed or not was confirmed. "O" was given when the adhesive could be easily removed, while "×" was given when the adhesive could not be removed.

The results are shown in Tables 1 and 2.

Table 1

| | Base material layer | | Antistatic layer | | |
|---|---|---|---|---|---|
| | Resin | Resin [μm] | Resin | Antistatic agent | Thickness [μm] |
| Antistatic film (A) | Random polypropylene WINTEC WFW4 | 50 | Random polypropylene WINTEC WFW4 | Pelestat VH230 | 10 |
| Antistatic film (B) | Random polypropylene WINTEC WFX4 | 50 | Random polypropylene WINTEC WFX4 | Pelestat VH230 | 10 |
| Antistatic film (C) | Random polypropylene F327 | 50 | Random polypropylene F327 | Pelestat VH230 | 10 |
| Antistatic film (D) | Random polypropylene WINTEC WFX4 | 50 | Random polypropylene F327 | Pelestat VH230 | 10 |
| Antistatic film (E) | Random polypropylene WINTEC WFX4 | 50 | Random polypropylene J-5710 | Pelestat VH230 | 10 |
| Antistatic film (F) | Homo polypropylene ZS1327A | 50 | Homo polypropyl ene ZS1327A | Pelestat VH230 | 10 |
| Non-antistatic film (G) | Random polypropylene WINTEC WFX4 | 60 | none | none | none |
| Non-antistatic film (H) | Random polypropylene WINTEC WFW4 | 60 | none | none | none |
| Non-antistatic film (I) | Random polypropylene F327 | 60 | none | none | none |
| Non-antistatic film (J) | Homo polypropylene ZS1327A | 60 | none | none | none |
| Antistatic film (K) | Polyethylene LF440C | 50 | Polyethylene L705 | Pelestat VH230 | 10 |
| Antistatic film (L) | Block polypropylene NEWSTREN SB8000 | 50 | Block polypropyl ene NEWSTREN SB8000 | Pelestat VH230 | 10 |
| Antistatic film (M) | Random polypropylene WINTEC WFX4 | 50 | Polyethylene Petrothene 0M05A | Pelestat VH230 | 10 |
| Antistatic film (N) | Antistatic-treated PET | 38 | - | - | - |
| Antistatic film (O) | Random polypropylene WINTEC WFX4 | 50 | Random polypropylene WINTEC WFX4 | Pelestat VH230 | 10 |
| Antistatic film (P) | Random polypropylene WINTEC WFX4 | 50 | Random polypropylene WINTEC WFX4 | Pelestat VH230 | 10 |
| Antistatic film (Q) | Random polypropylene WINTEC WFX4 | 50 | Random polypropylene WINTEC WFX4 | Pelestat VH230 | 10 |
| Antistatic film (R) | Random polypropylene WINTEC WFX4 | 50 | Random polypropylene WINTEC WFX4 | Resistat PE132 | 10 |

(continued)

| | Base material layer | | Antistatic layer | | |
|---|---|---|---|---|---|
| | Resin | Resin [μm] | Resin | Antistatic agent | Thickness [μm] |
| Antistatic film (S) | Random polypropylene WINTEC WFX4 | 50 | Random polypropylene WINTEC WFX4 | Entira MK400 | 10 |

Table 2

| | Total-light transmittance [%] | Haze [%] | Surface resistivity | | Initial peel adhesion [N/25mm] | Antifouling property [-] |
|---|---|---|---|---|---|---|
| | | | Initial surface resistivity [Ω/□] | Surface resistivity after washing with water [Ω/□] | | |
| Example 1 | 92.6 | 2.1 | $2.3\times10^{10}$ | $2.8\times10^{10}$ | 0.3 | ○ |
| Example 2 | 92.5 | 2.2 | $8.0\times10^{9}$ | $1.1\times10^{10}$ | 0.2 | ○ |
| Example 3 | 92.5 | 3.2 | $1.1\times10^{10}$ | $1.3\times10^{10}$ | 0.2 | ○ |
| Example 4 | 92.5 | 3.3 | $8.7\times10^{9}$ | $1.1\times10^{10}$ | 0.3 | ○ |
| Example 5 | 92.4 | 3.0 | $8.1\times10^{9}$ | $9.7\times10^{9}$ | 0.3 | ○ |
| Example 6 | 92.2 | 6.3 | $2.5\times10^{10}$ | $2.8\times10^{10}$ | 0.3 | ○ |
| Example 7 | 92.3 | 3.6 | $1.7\times10^{10}$ | $2.3\times10^{10}$ | 2.5 | ○ |
| Example 8 | 92.3 | 4.6 | $8.1\times10^{9}$ | $1.1\times10^{10}$ | 2.1 | ○ |
| Example 9 | 92.3 | 4.8 | $1.5\times10^{10}$ | $2.1\times10^{10}$ | 3.2 | ○ |
| Example 10 | 92.3 | 5.0 | $1.2\times10^{10}$ | $1.5\times10^{10}$ | 2.7 | ○ |
| Example 11 | 92.2 | 5.0 | $9.6\times10^{9}$ | $9.9\times10^{9}$ | 2.5 | ○ |
| Example 12 | 92.1 | 7.2 | $1.5\times10^{10}$ | $1.8\times10^{10}$ | 3.6 | ○ |
| Example 13 | 92.1 | 1.6 | $1.1\times10^{10}$ | $1.2\times10^{10}$ | 0.2 | ○ |
| Example 14 | 92.6 | 1.4 | $2.4\times10^{12}$ | $2.4\times10^{12}$ | 0.2 | ○ |
| Example 15 | 91.0 | 10.1 | $6.9\times10^{9}$ | $9.7\times10^{9}$ | 0.3 | ○ |
| Example 16 | 91.2 | 10.3 | $1.3\times10^{10}$ | $1.8\times10^{10}$ | 0.3 | ○ |
| Example 17 | 91.2 | 9.3 | $8.2\times10^{9}$ | $1.1\times10^{10}$ | 0.3 | ○ |
| Example 18 | 91.6 | 12.1 | $3.6\times10^{9}$ | $5.0\times10^{9}$ | 0.3 | ○ |
| Comparative Example 1 | 92.5 | 1.9 | $1.0\times10^{14}$ or more | unmeasured | 0.3 | ○ |
| Comparative Example 2 | 92.5 | 2.0 | $1.0\times10^{14}$ or more | unmeasured | 0.2 | ○ |
| Comparative Example 3 | 92.6 | 2.4 | $1.0\times10^{14}$ or more | unmeasured | 0.3 | ○ |
| Comparative Example 4 | 92.8 | 1.9 | $1.0\times10^{14}$ or more | unmeasured | 0.3 | ○ |
| Comparative Example 5 | 90.7 | 2.1 | $4.8\times10^{9}$ | unmeasured | 0.1 | × |
| Comparative Example 6 | 92.4 | 1.2 | $6.5\times10^{11}$ | $4.0\times10^{12}$ | 0.3 | ○ |

(continued)

| | Total-light transmittance [%] | Haze [%] | Surface resistivity | | Initial peel adhesion [N/25mm] | Antifouling property [-] |
|---|---|---|---|---|---|---|
| | | | Initial surface resistivity [Ω/□] | Surface resistivity after washing with water [Ω/□] | | |
| Comparative Example 7 | 91.6 | 41.4 | $6.4\times10^{14}$ | $2.6\times10^{14}$ | 0.3 | ○ |

From the results in Tables 1 and 2, it can be seen that when the pressure-sensitive adhesive sheets prepared according to the present invention (Examples 1 to 18) are used, transparent is particularly excellent and antistatic property is excellent in any of the Examples. It can also be seen that antifouling function is excellent in any of the Examples.

## Claims

1. Use of a removable pressure-sensitive adhesive sheet for protecting a surface of an optical member which sheet is provided on one side of a base material layer with a pressure-sensitive adhesive layer and on the other side thereof with an antistatic layer, wherein the antistatic layer comprises a polymeric antistatic agent comprising an olefin block and a hydrophilic block.

2. Use according to claim 1, wherein the antistatic layer comprises a propylene resin.

3. Use according to claim 1, wherein the antistatic layer comprises a propylene homopolymer and/or a propylene/α-olefin random copolymer.

4. Use according to claim 1, wherein the antistatic layer comprises a propylene/α-olefin random copolymer polymerized by using a metallocene catalyst.

5. Use according to claim 1, wherein the base material layer comprises a propylene resin.

6. Use according to claim 1, wherein the base material layer comprises a propylene homopolymer and/or propylene/α-olefin random copolymer.

7. Use according to claim 1, wherein the base material layer comprises a propylene/α-olefin random copolymer polymerized by using a metallocene catalyst.

8. Use according to claim 1, wherein the pressure-sensitive adhesive layer comprises a (meth)acrylic polymer based on one or more acrylates and/or methacrylates having an alkyl group containing 1 to 14 carbon atoms.

9. Use according to claim 8, wherein the pressure-sensitive adhesive layer is obtained by crosslinking the (meth)acrylic polymer.

10. An optical member, wherein a surface of the optical member is protected by a removable pressure-sensitive adhesive sheet and wherein the removable pressure-sensitive adhesive sheet is provided on one side of a base material layer with a pressure-sensitive adhesive layer and on the other side thereof with an antistatic layer, wherein the antistatic layer comprises a polymeric antistatic agent comprising an olefin block and a hydrophilic block.

## Patentansprüche

1. Verwendung einer entfernbaren druckempfindlichen adhäsiven Lage zum Schützen einer Oberfläche eines optischen Elements, wobei die Lage auf einer Seite einer Basismaterialschicht mit einer druckempfindlichen Adhäsivschicht und auf der anderen Seite davon mit einer antistatischen Schicht ausgestattet ist, wobei die antistatische Schicht ein polymeres antistatisches Agens umfasst, das einen Olefinblock und einen hydrophilen Block umfasst.

2. Verwendung nach Anspruch 1, wobei die antistatische Schicht ein Propylenharz umfasst.

3. Verwendung nach Anspruch 1, wobei die antistatische Schicht ein Propylenhomopolymer und/oder ein Propylen/α-olefin statistisches Copolymer umfasst.

4. Verwendung nach Anspruch 1, wobei die antistatische Schicht ein Propylen/α-olefin statistisches Copolymer umfasst, das durch Verwendung eines Metallocenkatalysators polymerisiert ist.

5. Verwendung nach Anspruch 1, wobei die Basismaterialschicht ein Propylenharz umfasst.

6. Verwendung nach Anspruch 1, wobei die Basismaterialschicht ein Propylenhomopolymer und/oder Propylen/α-olefin statistisches Copolymer umfasst.

7. Verwendung nach Anspruch 1, wobei die Basismaterialschicht ein Propylen/α-olefin statistisches Copolymer umfasst, das durch Verwendung eines Metallocenkatalysators polymerisiert ist.

8. Verwendung nach Anspruch 1, wobei die druckempfindliche Adhäsivschicht ein (Meth)acrylpolymer umfasst, das auf einem oder mehren Acrylaten und/oder Methacrylaten mit einer Alkylgruppe, die 1 bis 14 Kohlenstoffatome enthält, basiert.

9. Verwendung nach Anspruch 8, wobei die druckempfindliche Adhäsivschicht durch Quervernetzen des (Meth)acrylpolymers erhalten ist.

10. Optisches Element, wobei eine Oberfläche des optischen Elements durch eine entfernbare druckempfindliche adhäsive Lage geschützt ist und wobei die entfernbare druckempfindliche adhäsive Lage auf einer Seite einer Basismaterialschicht mit einer druckempfindlichen Adhäsivschicht und auf der anderen Seite davon mit einer antistatischen Schicht ausgestattet ist, wobei die antistatische Schicht ein polymeres antistatisches Agens umfasst, das einen Olefinblock und einen hydrophilen Block umfasst.

**Revendications**

1. Utilisation d'une feuille adhésive sensible à la pression, amovible pour protéger une surface d'un élément optique, laquelle feuille est pourvue sur un côté d'une couche de matériau de base d'une couche adhésive sensible à la pression et sur l'autre côté de celui-ci d'une couche antistatique, où la couche antistatique comprend un agent antistatique polymère comprenant un bloc d'oléfine et un bloc hydrophile.

2. Utilisation selon la revendication 1, dans laquelle la couche antistatique comprend une résine de propylène.

3. Utilisation selon la revendication 1, dans laquelle la couche antistatique comprend un homopolymère de propylène et/ou un copolymère aléatoire de propylène/α-oléfine.

4. Utilisation selon la revendication 1, dans laquelle la couche antistatique comprend un copolymère aléatoire de propylène/α-oléfine polymérisé en utilisant un catalyseur métallocène.

5. Utilisation selon la revendication 1, dans laquelle la couche de matériau de base comprend une résine de propylène.

6. Utilisation selon la revendication 1, dans laquelle la couche de matériau de base comprend un homopolymère de propylène et/ou un copolymère aléatoire de propylène/α-oléfine.

7. Utilisation selon la revendication 1, dans laquelle la couche de matériau de base comprend un copolymère aléatoire de propylène/α-oléfine polymérisé en utilisant un catalyseur métallocène.

8. Utilisation selon la revendication 1, dans laquelle la couche adhésive sensible à la pression comprend un polymère (méth)acrylique basé sur un ou plusieurs acrylate(s) et/ou méthacrylate(s) ayant un groupe alkyle contenant 1 à 14 atome(s) de carbone.

9. Utilisation selon la revendication 8, dans laquelle la couche adhésive sensible à la pression est obtenue par réticulation du polymère (méth)acrylique.

10. Élément optique, dans lequel une surface de l'élément optique est protégée par une feuille adhésive sensible à la pression, amovible où la feuille adhésive sensible à la pression, amovible est pourvue sur un côté d'une couche de matériau de base d'une couche adhésive sensible à la pression et sur l'autre côté de celui-ci d'une couche antistatique, où la couche antistatique comprend un agent antistatique polymère comprenant un bloc d'oléfine et un bloc hydrophile.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 7311160 A
- JP 2003089178 A
- JP 2005002220 A
- JP 2005125659 A
- JP 2004094012 A
- JP 2001096698 A
- JP 11256115 A
- JP 2005228856 A
- JP 2003282489 A
- JP 60035007 A
- JP 61130314 A
- JP 63295607 A
- JP 1275609 A
- JP 2041303 A
- JP 2131488 A
- JP 2076887 A
- JP 3163088 A
- JP 4300887 A
- JP 4211694 A
- JP 5043616 A
- JP 5209013 A
- JP 6239914 A
- JP 7504934 A
- JP 8085708 A
- JP 2001278985 A
- JP 2003048990 A
- JP 4053802 A


### Non-patent literature cited in the description


- Synthesis-Design and New Utility Development of Acryl Resin. Chubu Keiei Kaihatsu Center